# EUROPEAN PATENT APPLICATION

(11) **EP 4 848 338 A1**
(43) Date of publication of application: **02.12.2026**
(21) Application number: 25744964.5
(22) Date of filing: 07.01.2025
(51) Int. Cl.: H01L 23/12, F21V 15/01, H05K 1/02, F21Y 115/10

(54) **SUPPORT, INCLINE-MOUNTED MODULE, CIRCUIT MODULE, ELECTRONIC DEVICE, AND METHOD FOR MANUFACTURING CIRCUIT MODULE**

(30) Priority: 25.01.2024 JP 2024009526
(71) Applicant: Panasonic Intellectual Property Management Co., Ltd., Kadoma-shi, Osaka 571-0057 (JP)
(72) Inventor: OISHI, Koki, Kadoma-shi, Osaka 571-0057 (JP); OSHIO, Shozo, Kadoma-shi, Osaka 571-0057 (JP); MITSUOKA, Shun, Kadoma-shi, Osaka 571-0057 (JP); IIZAWA, Noboru, Kadoma-shi, Osaka 571-0057 (JP); SATO, Toshihiko, Kadoma-shi, Osaka 571-0057 (JP)
(74) Representative: Müller-Boré & Partner Patentanwälte PartG mbB
(86) International application number: PCT/JP2025/000104
(87) International publication number: WO 2025/158881

(57) **Abstract**

A support (1) to be mounted on a circuit board (3) while supporting an electronic component (2), the support including: a first mounting surface (1a) on which a mounting surface (2a) of the electronic component (2) is to be mounted; a second mounting surface (1b) via which the support (1) is to be mounted on the circuit board (3); a first electrode (11) and a second electrode (12) each made of a metal material and exposed on both the first mounting surface (1a) and the second mounting surface (1b); and a receiving portion (20) that receives a surface of the electronic component (2) different from the mounting surface (2a) of the electronic component (2). The first mounting surface (1a) is inclined at an inclination angle ranging from 5 to 85 degrees inclusive relative to the second mounting surface (1b), and the first electrode (11) and the second electrode (12) function as principal thermal conductors of the support (1) and conduct heat from the first mounting surface (1a) to the second mounting surface (1b).

## Description

### [Technical Field]

The present invention relates to an inclined mounting technique for mounting an electronic component at an angle and to applications thereof. Specifically, the present invention relates to, for example, a support for inclined mounting of an electronic component, an inclined mounting module including the support, a circuit module including the inclined mounting module, an electronic device including the support, and a method for manufacturing the circuit module.

### [Background Art]

Conventionally, inclined mounting techniques are known in which electronic components such as solid-state light-emitting elements or detection elements are mounted at an angle relative to a board (for example, Patent Literature (PTL) 1, 2, and 3).

When mounting electronic components on a board at an angle, it is conceivable to use a support having an inclined surface for inclined mounting. In this case, by mounting an electronic component on the inclined surface formed on the support, it is possible to obtain an inclined mounting module having a structure in which the electronic component is mounted on the support in an inclined orientation. Further, by mounting the inclined mounting module on a circuit board, it is possible to obtain a circuit module having a structure in which the electronic component mounted on the support is inclined relative to the circuit board. Note that surface-mount electronic components are predominant nowadays, and electrode materials containing copper as the main component are used for their mounting.

### [Citation List]

### [Patent Literature]

[PTL 1] Japanese Unexamined Patent Application Publication No. 2013-143319
[PTL 2] Japanese Patent No. 5007395
[PTL 3] WO2011/102335

### [Summary of Invention]

### [Technical Problem]

The support for inclined mounting has two mounting surfaces: a first mounting surface (inclined surface) on which an electronic component is to be mounted, and a second mounting surface via which the support itself is to be mounted on a board. These two mounting surfaces are not parallel. As a consequence, the manufacturing process of the circuit module becomes complex. In particular, when attempting to incline-mount a surface-mount electronic component, the manufacturing process of the circuit module becomes complex.

Specifically, when manufacturing a circuit module in which an electronic component is mounted at an angle relative to a circuit board using a support for inclined mounting, the following procedure is performed. First, a first mounting process is performed in which a first mounting surface of the support, that is, the surface on which the electronic component is to be mounted, is oriented horizontally, and the electronic component is mounted on the first mounting surface using solder. After the first mounting process, a second mounting process is performed in which the orientation of the support having the electronic component mounted thereon is changed such that a second mounting surface of the support (the surface to be mounted on the board) is oriented horizontally, and the support is mounted on the circuit board using solder. However, this method for manufacturing the circuit module has the following problems.

In the case of manufacturing a circuit module having the structure described above, the first mounting process for mounting the electronic component on the support involves applying solder paste to the support in advance, placing the electronic component on the support and then heating the electronic component and the support in a furnace, and cooling the electronic component and the support so that the electronic component is bonded to the support via solder. Similarly, the second mounting process for mounting the support on the circuit board involves applying solder paste to the circuit board in advance, placing the support on the circuit board and then heating the support and the circuit board in a furnace, and cooling the support and the circuit board so that the support is bonded to the circuit board via solder.

When manufacturing a circuit module having the structure described above, it is necessary to perform the mounting process by soldering (for example, a reflow process) at least twice. However, if the same type of solder is used in both the first mounting process and the second mounting process, the solder solidified in the first mounting process may melt in the second mounting process, which could result in a problem that the electronic component that was supposed to be fixed to the first mounting surface that is an inclined surface slides down the inclined surface and shifts from its predetermined position.

In view of the above, it is conceivable to use different solders having different melting points in the first mounting process and the second mounting process. However, doing so requires use of two soldering apparatuses (for example, reflow apparatuses) having different heating temperatures, which inevitably complicates the manufacturing process and increases the number of items that need to be controlled in the manufacturing process.

It is also conceivable to, while using the same type of solder in both the first mounting process and the second mounting process, lower the heating temperature in the second mounting process so that the solder used in the first mounting process does not melt. However, doing so risks degrading the mounting quality in the second mounting process.

The present invention has been made to address such problems, and has an object to provide a support and the like that enable manufacturing of an inclined mounting module by a simple process without employing advanced techniques.

### [Solution to Problem]

In order to achieve the above object, a support according to an aspect of the present invention is a support to be mounted on a board while supporting an electronic component, the support including, at least: one or more first mounting surfaces on which a mounting surface of the electronic component is to be mounted; a second mounting surface via which the support is to be mounted on the board; a first electrode and a second electrode each of which is made of a metal material and is exposed on both the one or more first mounting surfaces and the second mounting surface; and a receiving portion that receives a surface of the electronic component different from the mounting surface of the electronic component. The one or more first mounting surfaces are each inclined at an inclination angle of at least 5 degrees and at most 85 degrees relative to the second mounting surface. The first electrode and the second electrode function as principal thermal conductors of the support and conduct heat from the one or more first mounting surfaces to the second mounting surface.

In addition, an inclined mounting module according to an aspect of the present invention includes: the support described above; and an electronic component mounted on the one or more first mounting surfaces of the support.

In addition, a circuit module according to an aspect of the present invention includes: the inclined mounting module described above; and a board on which the support in the inclined mounting module is mounted. The support is mounted on the board via the second mounting surface, and the board is a circuit board.

In addition, an electronic device according to an aspect of the present invention includes: at least one of the inclined mounting module described above or the circuit module described above.

In addition, a method for manufacturing a circuit module according to an aspect of the present invention is a method for manufacturing the circuit module described above and includes: a first placing process of placing an electronic component on the one or more first mounting surfaces of the support via a first mounting material; a second placing process of placing the support on an electrode of the circuit board via a second mounting material; and a mounting process of mounting the electronic component on the support using the first mounting material and mounting the support on the circuit board using the second mounting material. The mounting process is performed after the first placing process and the second placing process.

In addition, a method for manufacturing a circuit module according to another aspect of the present invention is a method for manufacturing the circuit module described above and includes: a first mounting process of mounting an electronic component on the one or more first mounting surfaces of the support; an inclining process of inclining the support on which the electronic component has been mounted, the inclining process being performed after the first mounting process; and a second mounting process of mounting, on an electrode of the circuit board, the support on which the electronic component has been mounted, the support being mounted via the second mounting surface, the second mounting process being performed after the inclining process. A first mounting direction in which the electronic component is mounted on the support in the first mounting process and a second mounting direction in which the support is mounted on the electrode of the circuit board in the second mounting process are the same direction.

### [Advantageous Effects of Invention]

The present invention can provide a support that enables manufacturing of an inclined mounting module by a simple process without employing advanced techniques.

The present invention can also provide an inclined mounting module, a circuit module, an electronic device, and the like having favorable efficiency in: utilizing the active characteristics of an electronic component in an oblique direction relative to a principal surface of a board; and utilizing the passive characteristics of an electronic component with respect to physical properties arriving from an oblique direction relative to the principal surface of the board.

The present invention can also provide a method for manufacturing a circuit module that is a method by which a circuit module can be manufactured by a simple process.

### [Brief Description of Drawings]

[FIG. 1]

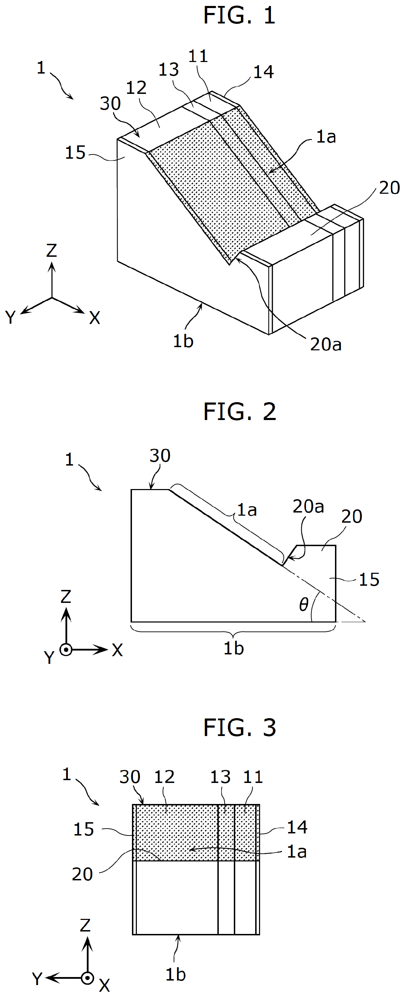

   FIG. 1 is a perspective view of a support according to Embodiment 1.
[FIG. 2]
   FIG. 2 is a side view of a support according to Embodiment 1.
[FIG. 3]
   FIG. 3 is a front view of a support according to Embodiment 1.
[FIG. 4]

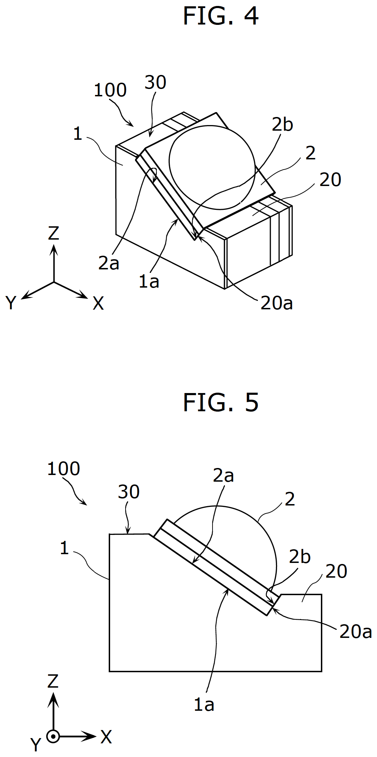

   FIG. 4 is a perspective view of an inclined mounting module according to Embodiment 1.
[FIG. 5]
   FIG. 5 is a side view of an inclined mounting module according to Embodiment 1.
[FIG. 6]

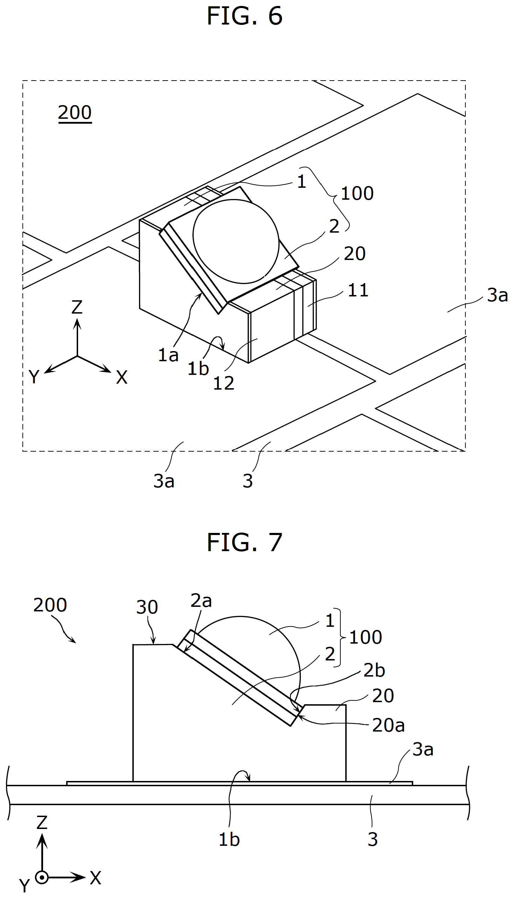

   FIG. 6 is a perspective view illustrating a portion of a circuit module according to Embodiment 1.
[FIG. 7]
   FIG. 7 is a side view illustrating a portion of a circuit module according to Embodiment 1.
[FIG. 8]

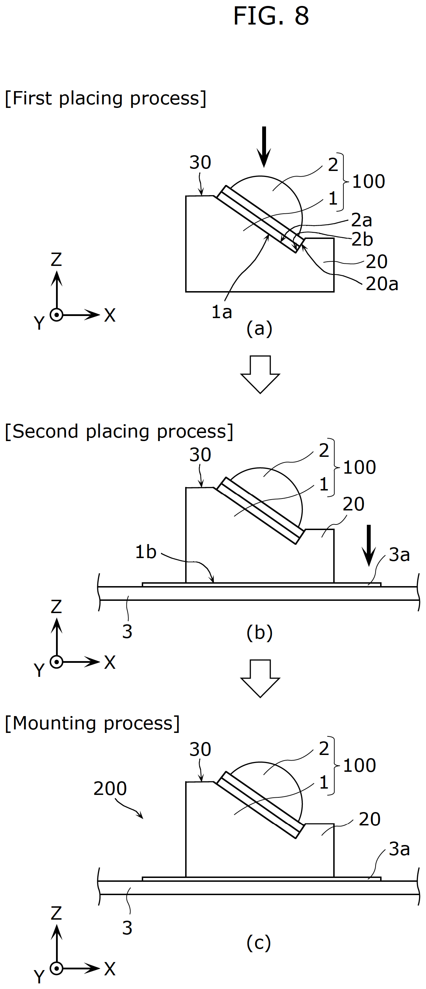

   FIG. 8 is a diagram for describing an example of a method for manufacturing a circuit module according to Embodiment 1.
[FIG. 9]

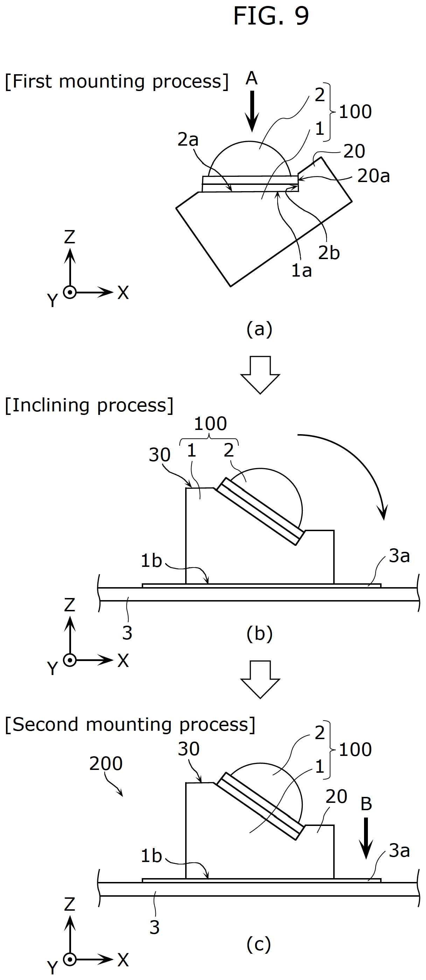

   FIG. 9 is a diagram for describing another example of a method for manufacturing a circuit module according to Embodiment 1.
[FIG. 10]

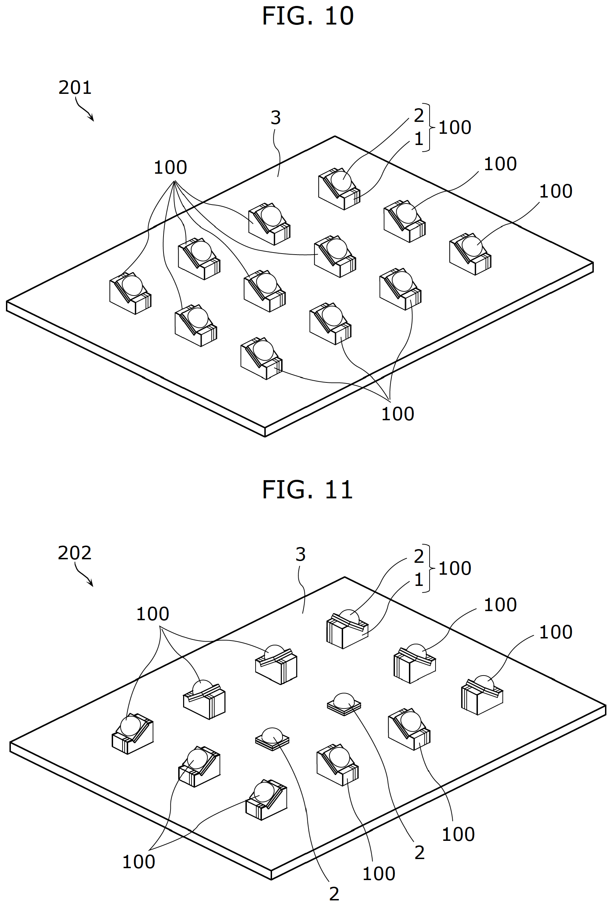

   FIG. 10 is a perspective view of a circuit module according to Variation 1 of Embodiment 1.
[FIG. 11]
   FIG. 11 is a perspective view of a circuit module according to Variation 2 of Embodiment 1.
[FIG. 12]

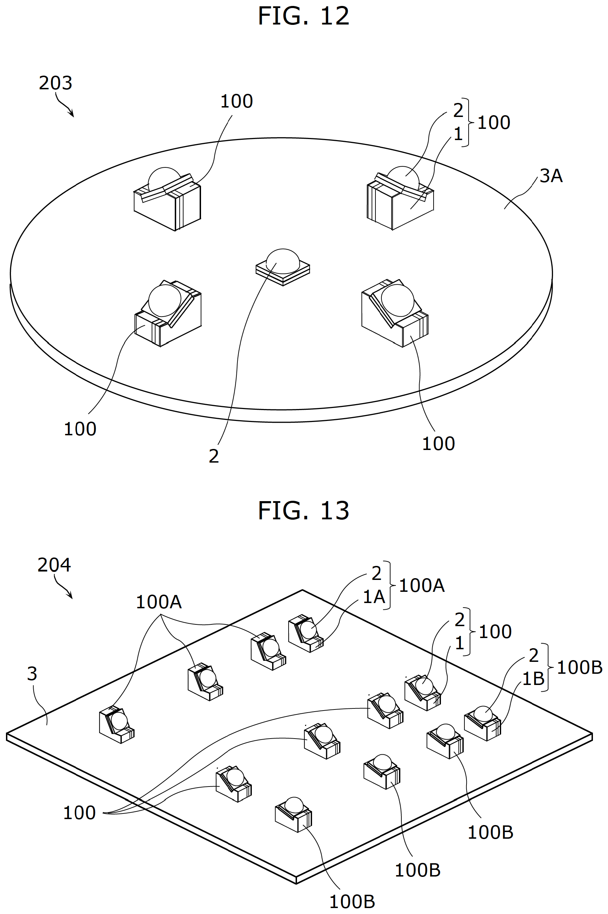

   FIG. 12 is a perspective view of a circuit module according to Variation 3 of Embodiment 1.
[FIG. 13]
   FIG. 13 is a perspective view of a circuit module according to Variation 4 of Embodiment 1.
[FIG. 14]

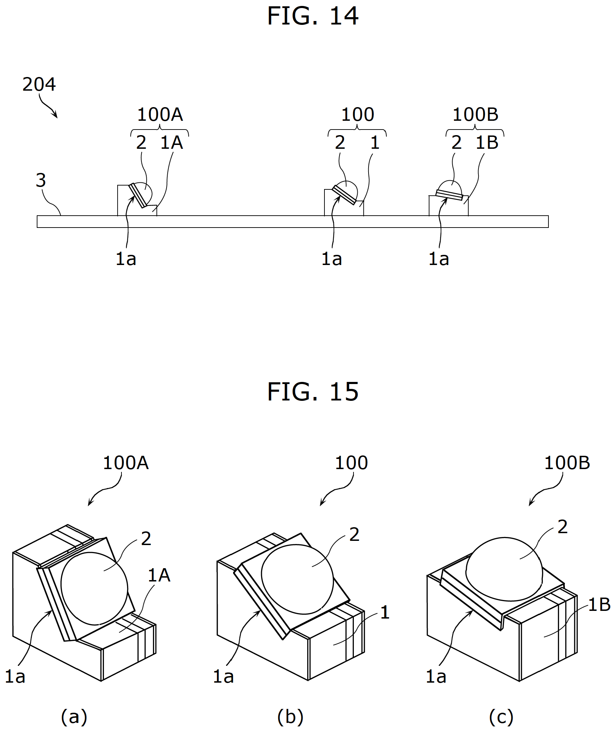

   FIG. 14 is a side view of a circuit module according to Variation 4 of Embodiment 1.
[FIG. 15]
   FIG. 15 is a perspective view of inclined mounting modules included in a circuit module according to Variation 4 of Embodiment 1.
[FIG. 16]

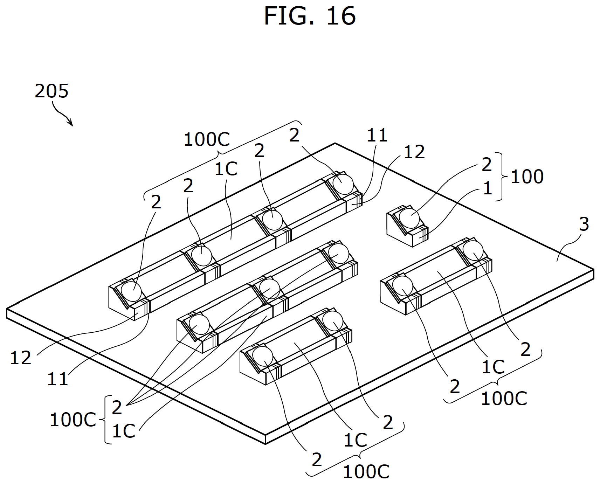

   FIG. 16 is a perspective view of a circuit module according to Variation 5 of Embodiment 1.
[FIG. 17]

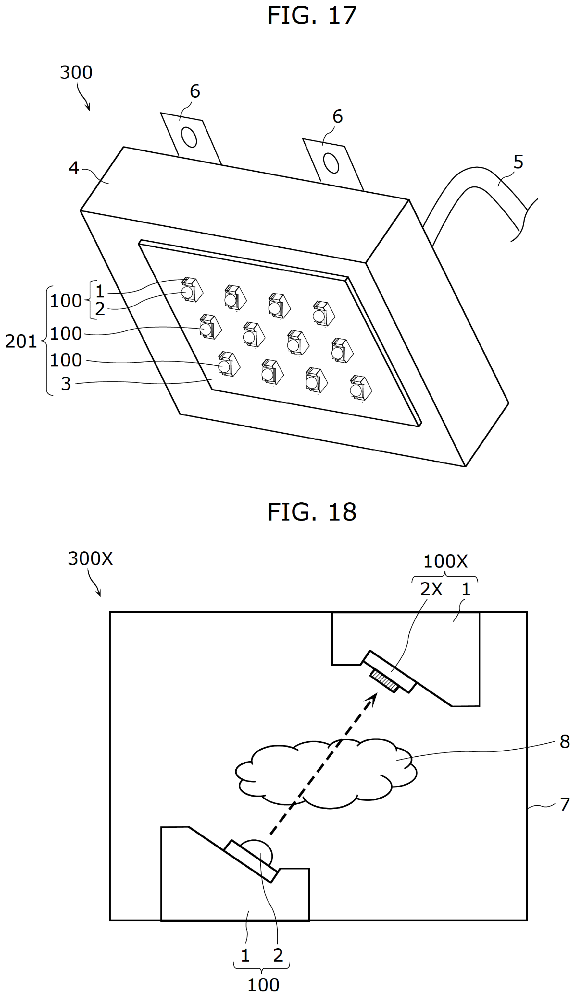

   FIG. 17 is a perspective view of an electronic device according to Embodiment 1.
[FIG. 18]
   FIG. 18 is a schematic view of an electronic device in another example according to Embodiment 1.
[FIG. 19]

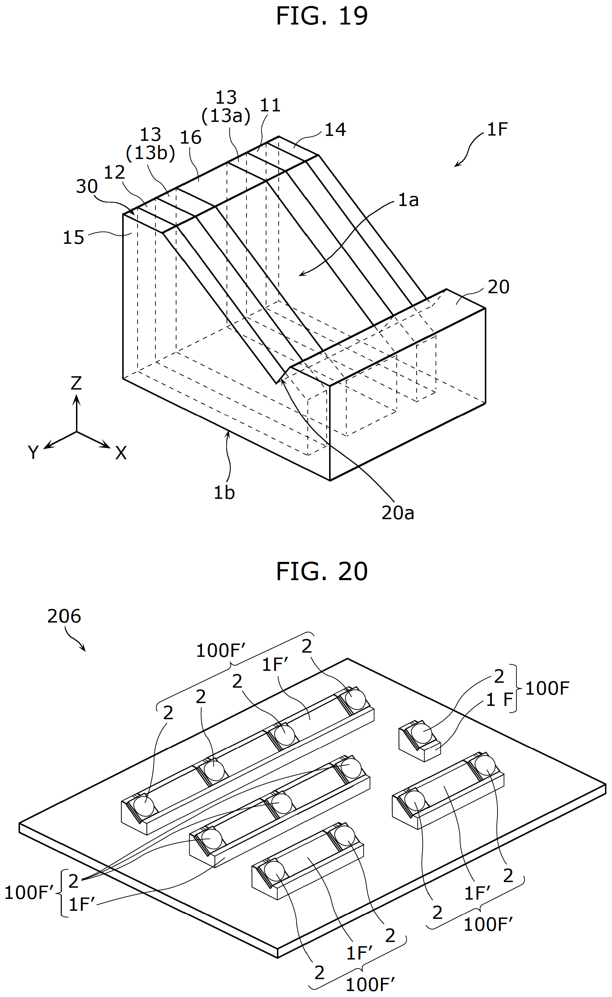

   FIG. 19 is a perspective view of a support according to Embodiment 2.
[FIG. 20]
   FIG. 20 is a perspective view of a circuit module according to Embodiment 2.
[FIG. 21]

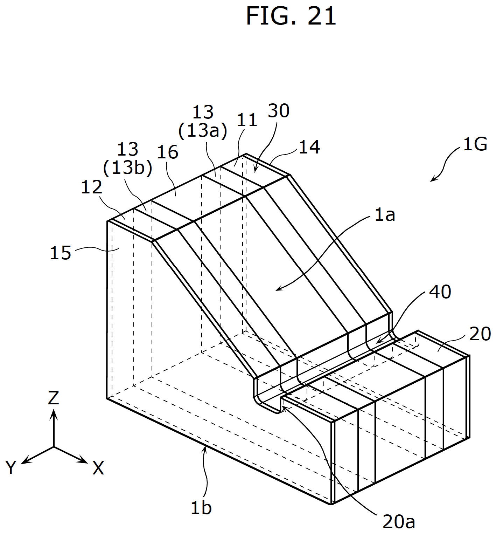

   FIG. 21 is a perspective view of a support according to Embodiment 3.
[FIG. 22]

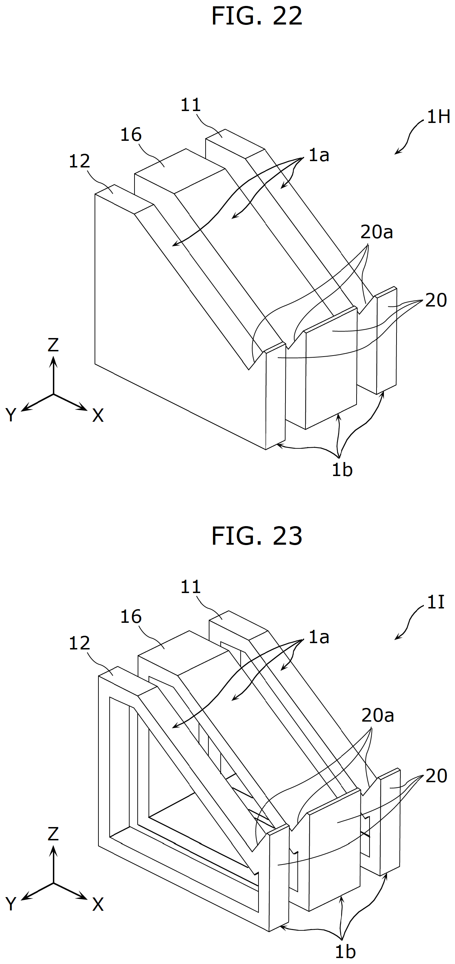

   FIG. 22 is a perspective view of a support according to Embodiment 4.
[FIG. 23]
   FIG. 23 is a perspective view of a support according to a variation of Embodiment 4.
[FIG. 24]

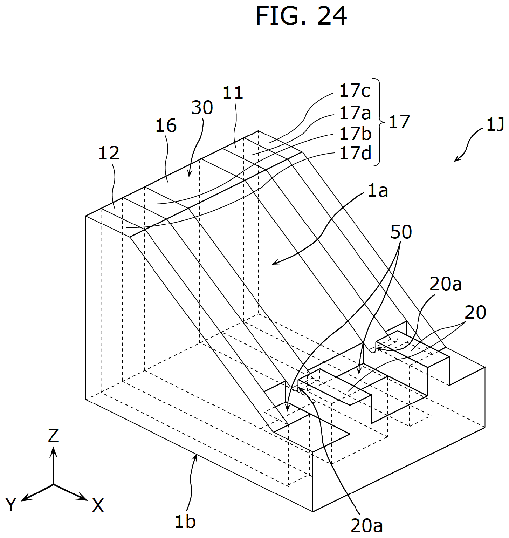

   FIG. 24 is a perspective view of a support according to Embodiment 5.
[FIG. 25]

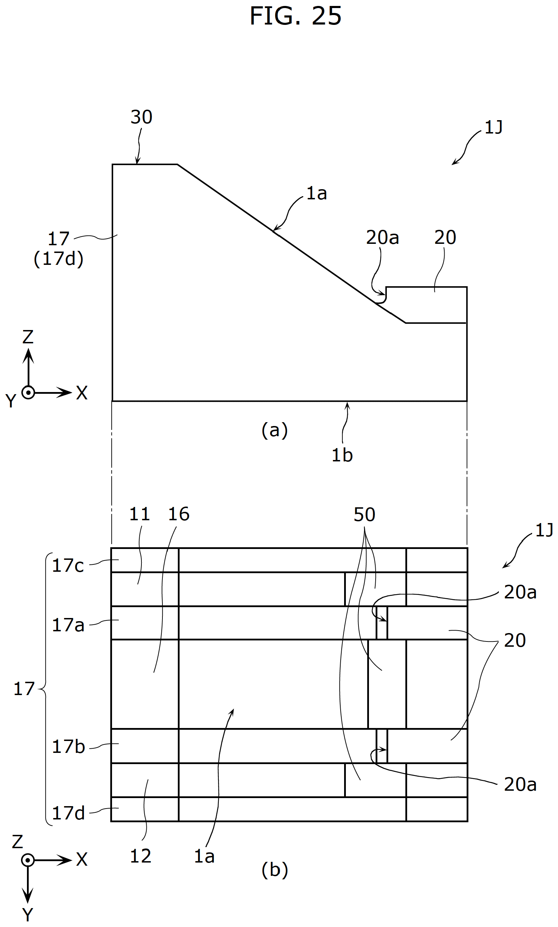

   FIG. 25 is a diagram illustrating the configuration of a support according to Embodiment 5.
[FIG. 26]

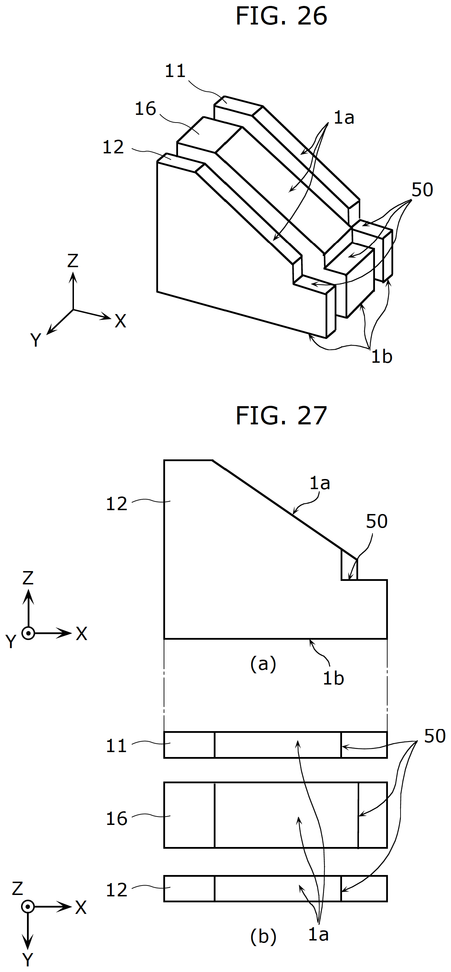

   FIG. 26 is a perspective view of a plurality of metal blocks (a first electrode, a second electrode, a fixing body) included in a support according to Embodiment 5.
[FIG. 27]
   FIG. 27 is a diagram illustrating the configuration of a plurality of metal blocks included in a support according to Embodiment 5.
[FIG. 28]

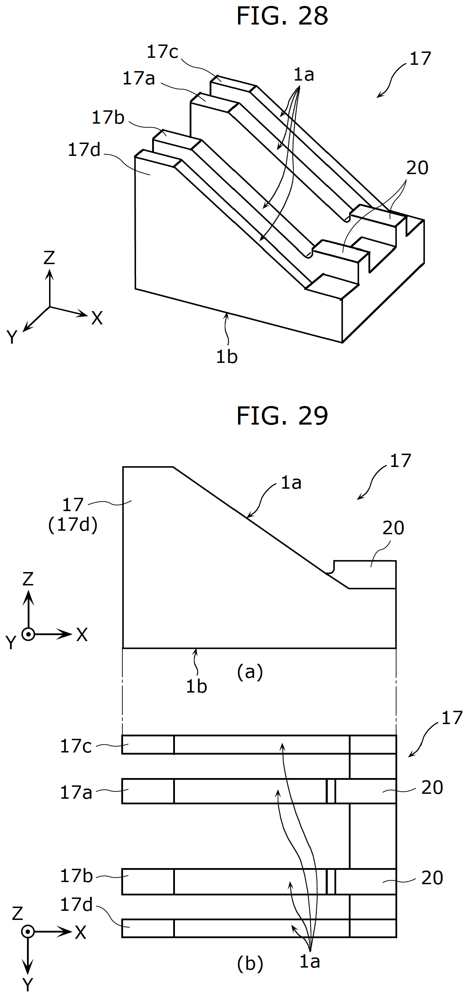

   FIG. 28 is a perspective view of a resin block included in a support according to Embodiment 5.
[FIG. 29]
   FIG. 29 is a diagram illustrating the configuration of a resin block included in a support according to Embodiment 5.
[FIG. 30]

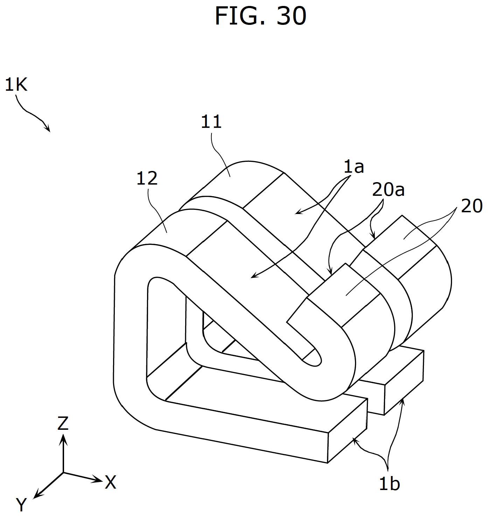

   FIG. 30 is a perspective view of a support according to Embodiment 6.
[FIG. 31]

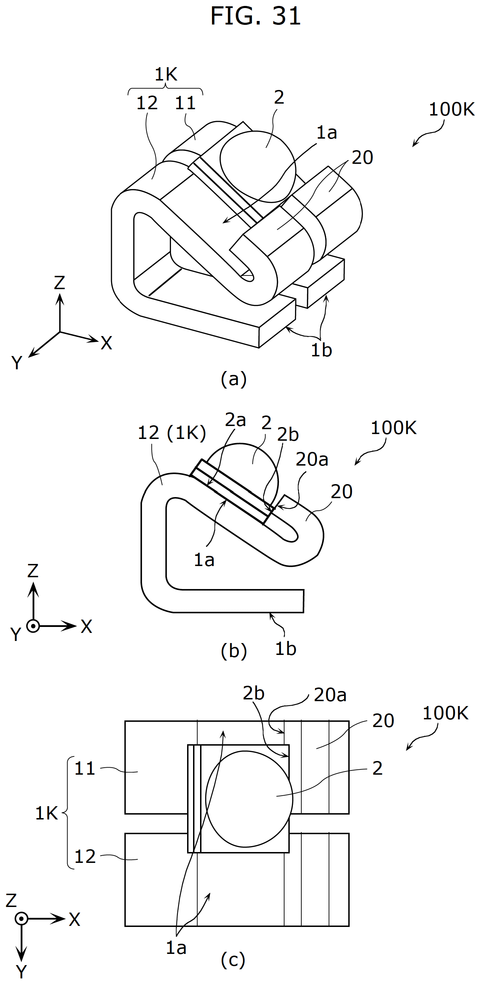

   FIG. 31 is a perspective view of an inclined mounting module according to Embodiment 6.
[FIG. 32]

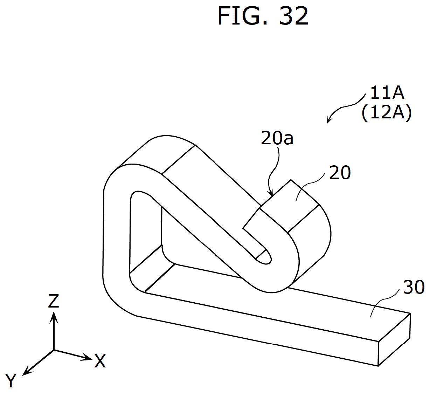

   FIG. 32 is a perspective view illustrating a variation of a first electrode included in a support according to Embodiment 6.
[FIG. 33]

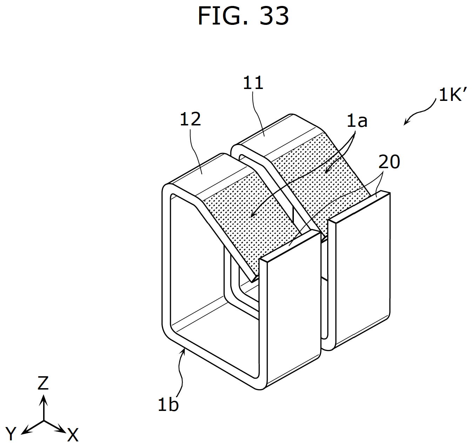

   FIG. 33 is a perspective view of a support according to a variation of Embodiment 7.
[FIG. 34]

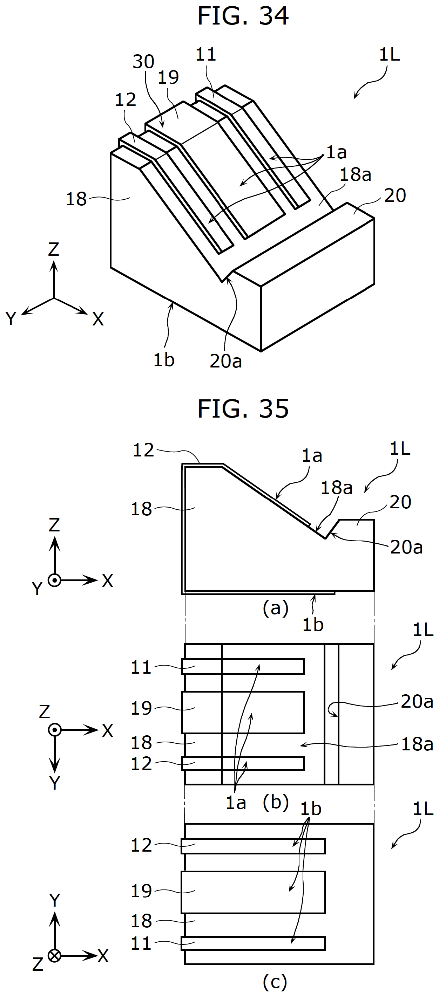

   FIG. 34 is a perspective view of a support according to Embodiment 7.
[FIG. 35]
   FIG. 35 is a diagram illustrating the configuration of a support according to Embodiment 7.
[FIG. 36]

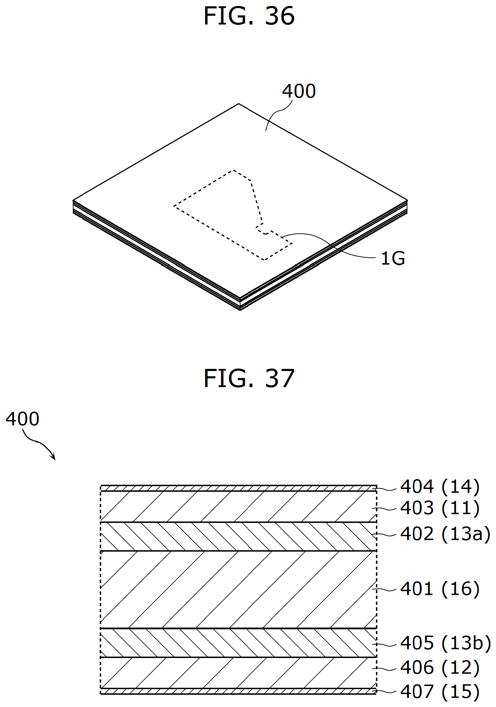

   FIG. 36 is a perspective view of a multilayer substrate used for fabricating a variation of a support according to Embodiment 3.
[FIG. 37]
   FIG. 37 is a cross-sectional view of a multilayer substrate used for fabricating a variation of a support according to Embodiment 3.
[FIG. 38]

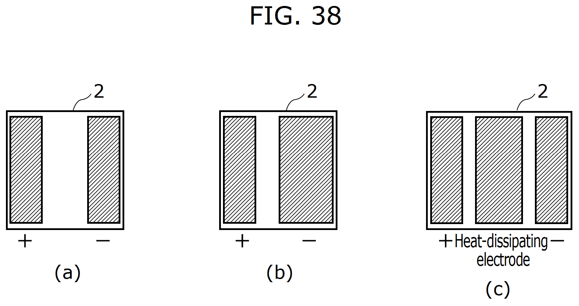

   FIG. 38 is a diagram illustrating electrode patterns of an electronic component.

### [Description of Embodiments]

Hereinafter, embodiments of the present invention will be described with reference to the drawings. Each of the embodiments described below shows a specific example of the present invention. Therefore, the numerical values, shapes, materials, constituent elements, the arrangement and connection of the constituent elements, etc. shown in the following embodiments are mere examples, and are not intended to limit the present invention. Thus, among the constituent elements in the following embodiments, those not recited in any of the independent claims representing the most generic concepts of the present invention will be described as optional constituent elements.

Note that the drawings are represented schematically and are not necessarily precise illustrations. Additionally, constituent elements that are substantially the same are given the same reference signs in the drawings, and redundant descriptions will be omitted or simplified. In each drawing, X-axis, Y-axis, and Z-axis represent the three axes of a three-dimensional Cartesian coordinate system, and in the present embodiment, the Z-axis direction is the vertical direction, and the direction perpendicular to the Z-axis (the direction parallel to the XY plane) is the horizontal direction. The X-axis and Y-axis are orthogonal to each other and are each orthogonal to the Z-axis. Note that in the present specification, the terms "upper", "up", "upward" "lower", and "down" do not necessarily refer to the absolute upward and downward directions (vertically up and vertically down) in space recognition.

### [Embodiment 1]

First, the configuration of support 1 according to Embodiment 1 will be described with reference to FIG. 1 through FIG. 3. FIG. 1 is a perspective view of support 1 according to Embodiment 1. FIG. 2 is a side view of support 1 according to Embodiment 1. FIG. 3 is a front view of support 1 according to Embodiment 1.

Support 1 is a support member that supports an electronic component (not illustrated) mounted thereon. Support 1 that supports the electronic component is mounted on, for example, a board (not illustrated) such as a circuit board. Therefore, as illustrated in FIG. 1 through FIG. 3, support 1 includes at least first mounting surface 1a, which is the surface on which the mounting surface of the electronic component is to be mounted, and second mounting surface 1b, which is the surface via which support 1 is to be mounted on the board.

First mounting surface 1a and second mounting surface 1b are exposed surfaces of support 1. Specifically, first mounting surface 1a is the surface (upper surface) on the upper side of support 1, and second mounting surface 1b is the surface (lower surface) on the lower side of support 1. First mounting surface 1a and second mounting surface 1b are each a flat plane (for example, surface irregularities are ±0.25 mm or less). Note that each of first mounting surface 1a and second mounting surface 1b may be divided into a plurality of surfaces. That is, each of first mounting surface 1a and second mounting surface 1b may include a plurality of separate surfaces.

First mounting surface 1a is an inclined surface that is inclined relative to second mounting surface 1b. Specifically, first mounting surface 1a is inclined at inclination angle θ of at least 5 degrees and at most 85 degrees relative to second mounting surface 1b (see FIG. 2). Therefore, first mounting surface 1a and second mounting surface 1b are not parallel to each other. Inclination angle θ of first mounting surface 1a is preferably at least 10 degrees and at most 60 degrees, more preferably at least 20 degrees and at most 50 degrees. Note that, in the present embodiment, first mounting surface 1a is the entirety of the inclined surface formed on support 1. That is, first mounting surface 1a is the region indicated by dotted hatching in FIG. 1 and FIG. 3. In the present embodiment, second mounting surface 1b is the entirety of the lower surface of support 1. Note that first mounting surface 1a may be a portion of the inclined surface of support 1, and second mounting surface 1b may be a portion of the lower surface of support 1. For example, first mounting surface 1a and second mounting surface 1b can be regions where solder is formed.

In the present embodiment, first mounting surface 1a is a single surface, but the present disclosure is not limited thereto. Specifically, support 1 may include a plurality of first mounting surfaces 1a having different inclination angles θ. That is, it suffices so long as support 1 includes one or more first mounting surfaces 1a. Note that, in the case where a plurality of first mounting surfaces 1a having different inclination angles are formed on support 1, the vectors parallel to the respective first mounting surfaces 1a are directed in one direction, for example. In this case, the plurality of first mounting surfaces 1a having different inclination angles may be arranged separately in the longitudinal direction (upper and lower sides) or the transverse direction (left and right sides) to face one direction.

In the present embodiment, one first mounting surface 1a is a single surface, but the present disclosure is not limited thereto. For example, first mounting surface 1a may be divided into a plurality of surfaces. That is, first mounting surface 1a may include a plurality of surfaces having the same inclination angle θ. Likewise, second mounting surface 1b may also be divided into a plurality of surfaces.

As illustrated in FIG. 1 through FIG. 3, support 1 includes first electrode 11, second electrode 12, and insulator 13. Support 1 further includes first protector 14 and second protector 15. Each of first electrode 11, second electrode 12, insulator 13, first protector 14, and second protector 15 is bonded to an adjacent member.

First electrode 11 and second electrode 12 are electrodes for supplying electric power to the electronic component mounted on first mounting surface 1a. For example, one of first electrode 11 or second electrode 12 is a positive electrode, and the other is a negative electrode. Note that, when the electronic component mounted on support 1 is driven by an AC voltage instead of a DC voltage, first electrode 11 and second electrode 12 need not be distinguished as a positive electrode and a negative electrode.

Each of first electrode 11 and second electrode 12 is exposed on first mounting surface 1a. Each of first electrode 11 and second electrode 12 is also exposed on second mounting surface 1b. Therefore, electric power can be supplied from second mounting surface 1b to the electronic component mounted on first mounting surface 1a. Specifically, by mounting support 1 on a circuit board via second mounting surface 1b, electric power can be supplied to positive and negative electrodes of the electronic component mounted on first mounting surface 1a via the pair of first electrode 11 and second electrode 12. That is, first electrode 11 and second electrode 12 function as electrical conductors.

First electrode 11 and second electrode 12 not only function as electrical conductors but also function as thermal conductors that conduct heat. Specifically, first electrode 11 and second electrode 12 conduct heat from first mounting surface 1a to second mounting surface 1b. In the present embodiment, first electrode 11 and second electrode 12 function as principal thermal conductors of support 1. That is, although support 1 includes some heat-conductive members that conduct heat from first mounting surface 1a to second mounting surface 1b, first electrode 11 and second electrode 12 conduct the greatest amount of heat from first mounting surface 1a to second mounting surface 1b among those heat-conductive members. Therefore, heat generated by the electronic component mounted on first mounting surface 1a is conducted from first mounting surface 1a to second mounting surface 1b via first electrode 11 and second electrode 12 and dissipated.

The electrode material used for first electrode 11 and second electrode 12 is a material having electrical conductivity. The electrode material used for first electrode 11 and second electrode 12 is not particularly limited so long as it has electrical conductivity; however, from the viewpoints of workability and thermal conduction, the electrode material contains metal, for example. In the present embodiment, first electrode 11 and second electrode 12 are made of a metal material. As an example, first electrode 11 and second electrode 12 are at least one selected from, for instance, aluminum, gold, silver, copper, or an alloy containing any of these. These metal materials are metals having a thermal conductivity exceeding 200 W/m·K at room temperature. In particular, since the thermal conductivities of gold, silver, and copper exceed 300 W/m·K, forming first electrode 11 and second electrode 12 of gold, silver, or copper yields support 1 having excellent thermal conductivity from first mounting surface 1a to second mounting surface 1b. Also, taking manufacturing cost into consideration, first electrode 11 and second electrode 12 may be copper electrodes containing copper as the main component. In this case, first electrode 11 and second electrode 12 may be made of a metal material (for example, brass, bronze, copper) containing at least 30 wt% copper, preferably at least 40 wt% copper.

In the present embodiment, first electrode 11 and second electrode 12 are plate-shaped metal blocks, and end surfaces of the metal blocks form part of first mounting surface 1a and second mounting surface 1b. Thus, some of the surfaces of first electrode 11 and second electrode 12 form part of first mounting surface 1a and second mounting surface 1b. Specifically, first electrode 11 and second electrode 12 are flat plate-shaped metal blocks each having a constant thickness. First electrode 11 and second electrode 12 are disposed parallel to each other.

Note that the volume fraction of metal in support 1 (for example, the volume fraction of first electrode 11 and second electrode 12 in support 1) is at least 30%, for example, preferably greater than 50%, for example. Accordingly, support 1 having excellent thermal conductivity from first mounting surface 1a to second mounting surface 1b can be obtained.

Since first electrode 11 and second electrode 12 are exposed on each of first mounting surface 1a and second mounting surface 1b, the envelope volume of each of first electrode 11 and second electrode 12 can be increased. Thus, first electrode 11 and second electrode 12 serve as heat-conductive members, enabling heat generated by the electronic component mounted on first mounting surface 1a to be efficiently conducted to second mounting surface 1b via first electrode 11 and second electrode 12, and dissipated.

At least on first mounting surface 1a, each of first electrode 11 and second electrode 12 extends in the inclination direction of first mounting surface 1a. That is, the portions of first electrode 11 and second electrode 12 exposed on first mounting surface 1a extend in the inclination direction of first mounting surface 1a. Note that each of first electrode 11 and second electrode 12 extends also on second mounting surface 1b. Specifically, on second mounting surface 1b, each of first electrode 11 and second electrode 12 extends in the X-axis direction.

First electrode 11 and second electrode 12 have different electrode widths on first mounting surface 1a and second mounting surface 1b. Specifically, the electrode width of second electrode 12 is greater than the electrode width of first electrode 11 on each of first mounting surface 1a and second mounting surface 1b. Note that the electrode width of first electrode 11 and the electrode width of second electrode 12 may be the same.

Insulator 13 is located between first electrode 11 and second electrode 12. Insulator 13 is an electrically insulating member for electrically insulating first electrode 11 and second electrode 12 from each other. Insulator 13 is made of an electrically insulating material having an electrically insulating property. Examples of the electrically insulating material forming insulator 13 include resin and ceramics.

Insulator 13 is exposed on each of first mounting surface 1a and second mounting surface 1b. In the present embodiment, insulator 13 is a plate-shaped, electrically insulating member, and end surfaces of insulator 13 form part of first mounting surface 1a and second mounting surface 1b. Thus, some of the surfaces of insulator 13 form part of first mounting surface 1a and second mounting surface 1b. Specifically, insulator 13 is a flat plate-shaped, electrically insulating member having a constant thickness.

Plate-shaped insulator 13 is sandwiched between first electrode 11 and second electrode 12. Accordingly, one side surface of insulator 13 contacts a side surface of first electrode 11, and the other side surface of insulator 13 contacts a side surface of second electrode 12. Therefore, first electrode 11 and second electrode 12 are separated from each other by the width of insulator 13. Note that insulator 13 need not be a tangible object, and may merely be a void (an air layer). That is, first electrode 11 and second electrode 12 may be insulated and separated from each other by a void.

First protector 14 covers the side surface of first electrode 11 opposite to the side surface of first electrode 11 facing insulator 13. Second protector 15 covers the side surface of second electrode 12 opposite to the side surface of second electrode 12 facing insulator 13. First protector 14 and second protector 15 constitute part of the outer peripheral portion of support 1.

In the present embodiment, first protector 14 and second protector 15 are protective films or protective plates that are smaller than first electrode 11 and second electrode 12 in thickness. First protector 14 and second protector 15 are made of, for example, a metal material or a resin material. That is, first protector 14 and second protector 15 are metal films or resin films, or metal plates or resin plates. Note that first protector 14 and second protector 15 may be made of materials other than metal materials or resin materials. First protector 14 and second protector 15 may be made of an electrically conductive material having electrical conductivity such as a metal material, but may be made of an electrically insulating material having an electrically insulating property, such as an electrically insulating resin material. Accordingly, the outer peripheral portion of support 1 can be an insulating portion rather than a charging portion. Note that support 1 need not include first protector 14 and second protector 15. That is, the respective side surfaces of first electrode 11 and second electrode 12 may be exposed.

Although not illustrated, support 1 may include a fixing body for the purpose of ensuring mechanical strength of support 1 against vibration. Further, support 1 may include a heat-dissipating body for dissipating heat generated by the electronic component. In this case, the fixing body may also serve as the heat-dissipating body, or the heat-dissipating body may also serve as the fixing body. Also, first electrode 11 may also serve as the fixing body and/or the heat-dissipating body. Second electrode 12 may also serve as the fixing body and/or the heat-dissipating body.

Support 1 includes receiving portion 20 that receives a surface of the electronic component different from the mounting surface of the electronic component (the surface to be bonded to first mounting surface 1a). Receiving portion 20 includes receiving surface 20a that receives the surface of the electronic component different from the mounting surface of the electronic component.

When the mounting surface of the electronic component is the rear surface of the electronic component, receiving portion 20 receives a side surface of the electronic component. That is, when the mounting surface of the electronic component is disposed on first mounting surface 1a of support 1, receiving surface 20a of receiving portion 20 receives a side surface of the electronic component. At this time, receiving portion 20 may receive the entire side surface of the electronic component or may receive part of the side surface of the electronic component. Receiving portion 20 functions as a positional displacement preventing portion that prevents the electronic component disposed on first mounting surface 1a from moving in a direction in which the distance between first mounting surface 1a and second mounting surface 1b decreases (that is, toward the lower side of first mounting surface 1a). That is, by the electronic component abutting receiving surface 20a of receiving portion 20, movement of the electronic component is restricted. In the present embodiment, receiving portion 20 is a protruding portion protruding from first mounting surface 1a. In this case, receiving surface 20a of receiving portion 20 is a side wall surface of the protruding portion.

Support 1 includes suction portion 30 to which a suction nozzle is to be attached by suction when support 1 is mounted on a board. Suction portion 30 is a plane that is located on the back side of second mounting surface 1b and is parallel to second mounting surface 1b. Therefore, the plane serving as suction portion 30 is inclined relative to first mounting surface 1a. In the present embodiment, the plane serving as suction portion 30 is formed continuously with first mounting surface 1a. Specifically, suction portion 30 is constituted by exposed surfaces of first electrode 11, second electrode 12, and insulator 13.

By providing suction portion 30 to support 1 as described above, support 1 can be readily attached and detached in a direction perpendicular to second mounting surface 1b using, for example, a mounting machine that includes a suction nozzle. As a result, support 1 can be handled and readily placed on a board using a mounting machine for industrial production. Specifically, a suction nozzle is attached to suction portion 30 of support 1 by suction to operate support 1 in the up-down direction and place support 1 on a board that is disposed to be parallel to the horizontal plane extending in the direction perpendicular to the gravity direction, thereby enabling easy mounting of support 1 on the board.

Note that, in the present embodiment, suction portion 30 is provided on the top surface of support 1; however, the position of suction portion 30 in support 1 is not particularly limited. For example, suction portion 30 may be provided at the bottom portion of support 1 or at an intermediate position in the height direction.

The envelope volume of support 1 configured as described above is, for example, at least 25 mm³ (0.025 cm³) and at most 30 cm³, preferably at least 30 mm³ (0.030 cm³) and at most 8000 mm³ (8 cm³), and particularly preferably at least 30 mm³ (0.030 cm³) and at most 1000 mm³ (1 cm³). By imparting such an envelope volume to support 1, support 1 becomes suitable for the mounting of an electronic component, such as a light-emitting diode (LED), at an angle on first mounting surface 1a that is inclined.

As illustrated in FIG. 4 and FIG. 5, inclined mounting module 100 can be obtained by mounting electronic component 2 on first mounting surface 1a of support 1. That is, inclined mounting module 100 includes support 1 and electronic component 2 mounted on first mounting surface 1a of support 1. FIG. 4 is a perspective view of inclined mounting module 100 according to Embodiment 1. FIG. 5 is a side view of inclined mounting module 100 according to Embodiment 1.

Electronic component 2 mounted on support 1 is, for example, a solid-state light-emitting element such as an LED or a semiconductor laser. In the present embodiment, electronic component 2 is an LED. Specifically, electronic component 2 is a surface-mount-device (SMD) type LED element that is individually packaged. For example, a white LED package (package size: 3.5 mm × 3.5 mm × 2.35 mm) can be used as electronic component 2.

When electronic component 2 is a solid-state light-emitting element, the type of light emitted by the solid-state light-emitting element is not particularly limited. For example, a solid-state light-emitting element that emits one electromagnetic wave selected from ultraviolet, visible light, and infrared can be used as electronic component 2.

Here, at least one selected from UV-A (315 nm to 400 nm), UV-B (280 nm to 315 nm), and UV-C (100 nm to 280 nm) can be used as ultraviolet.

Also, at least one selected from, for example, violet light (380 nm to 430 nm), blue light (430 nm to 490 nm), green light (490 nm to 550 nm), yellow light (550 nm to 590 nm), orange light (590 nm to 640 nm), red light (640 nm to 780 nm), and white light can be used as visible light.

In this case, at least one selected from, for example, warm white (correlated color temperature: 2600 K to 3250 K), warm neutral white (3250 K to 3800 K), neutral white (3800 K to 4500 K), cool white (4600 K to 5500 K), and daylight (5700 K to 7100 K) can be used as white light.

Also, at least one selected from IR-A (0.78 µm to 1.4 µm), IR-B (1.4 µm to 3 µm), and IR-C (3 µm to 1000 µm) can be used as infrared.

Note that electronic component 2 need not have an active characteristic such as outputting light like a solid-state light-emitting element etc., and may have a passive characteristic to receive physical properties. For example, electronic component 2 may be a detection element (sensor), such as a semiconductor detection element, that receives physical properties such as light, sound, temperature, pressure, or odor. As the detection element, it is possible to use, for example, a light detection element that detects light, a sound detection element that detects sound, a temperature detection element that detects temperature, a pressure detection element that detects pressure, and an odor detection element that detects odor.

As the light detection element, it is possible to use, for example, a photodiode, a charge coupled device (CCD), or a complementary metal-oxide-semiconductor (CMOS) image sensor. As the sound detection element, it is possible to use a piezoelectric element or a condenser microphone, for example. As the temperature detection element, it is possible to use a thermoelectric element or a thermistor, for example. As the pressure detection element, it is possible to use a semiconductor pressure sensor, for example. As the odor detection element, it is possible to use a semiconductor gas sensor, for example. Note that the types of detection targets detected by the detection element are not limited to light, sound, temperature, pressure, odor, and the like.

Electronic component 2 may be other than a solid-state light-emitting device or a detection element. In any case, electronic component 2 may be of the SMD type. This eliminates the need for separate processing to mount electronic component 2 on first mounting surface 1a of support 1, and electronic component 2 can be mounted on support 1 merely by placing electronic component 2 on first mounting surface 1a via a bonding material such as solder. Thus, inclined mounting module 100 having excellent industrial producibility can be obtained.

When mounting electronic component 2 on support 1, electronic component 2 can be mounted on first mounting surface 1a of support 1 by a mounting technique using a bonding material. Thus, although not illustrated, a bonding material is present between first mounting surface 1a of support 1 and electronic component 2. For example, solder can be used as the bonding material that bonds support 1 and electronic component 2. In this case, electronic component 2 can be mounted on support 1 by a soldering-based mounting technique using solder.

Electronic component 2 is mounted on first mounting surface 1a of support 1. Electronic component 2 mounted on support 1 abuts receiving portion 20 of support 1. In the present embodiment, side surface 2b of electronic component 2 abuts receiving surface 20a of receiving portion 20. Specifically, when mounting surface 2a of electronic component 2 is disposed on first mounting surface 1a of support 1, receiving surface 20a of receiving portion 20 abuts side surface 2b of electronic component 2.

Also, since first mounting surface 1a of support 1 is an inclined surface that is inclined relative to second mounting surface 1b, electronic component 2 mounted on first mounting surface 1a is in an inclined orientation when mounted on support 1. As a result, when inclined mounting module 100 is mounted on a board, electronic component 2 is inclined relative to a principal surface of the board.

For example, when electronic component 2 is a solid-state light-emitting element, an illumination module capable of outputting, in an oblique direction relative to the principal surface of the board, light emitted by the solid-state light-emitting element can be obtained as inclined mounting module 100. Further, when electronic component 2 is a detection element, a sensor module capable of detecting physical properties (such as light) incident in an oblique direction relative to the principal surface of the board can be obtained as inclined mounting module 100.

Thus, according to inclined mounting module 100 of the present embodiment, it is possible to achieve favorable efficiency in: utilizing the active characteristic of electronic component 2 in an oblique direction relative to the principal surface of the board; or utilizing the passive characteristic of electronic component 2 with respect to physical properties arriving from an oblique direction relative to the principal surface of the board.

Note that the outer contour shape of at least one of first electrode 11 or second electrode 12 exposed on first mounting surface 1a of support 1 may be the same as or substantially the same as the outer contour shape of one of a first electrode or a second electrode exposed on the mounting surface of electronic component 2 that is bonded via solder. Accordingly, one of the first electrode or the second electrode exposed on the mounting surface of electronic component 2 is bonded by molten solder to one of first electrode 11 or second electrode 12 exposed on first mounting surface 1a such that their outer contour shapes match each other. That is, it is possible to inhibit electronic component 2 mounted on first mounting surface 1a from rotating and shifting in position on first mounting surface 1a when the molten solder solidifies. Accordingly, inclined mounting module 100 suitable for precise control of the mounting position of electronic component 2 can be obtained.

Moreover, not only one but both of the following may apply: the outer contour shape of first electrode 11 of support 1 exposed on first mounting surface 1a is the same as or substantially the same as the outer contour shape of the first electrode exposed on the mounting surface of electronic component 2; and the outer contour shape of second electrode 12 of support 1 exposed on first mounting surface 1a is the same as or substantially the same as the outer contour shape of the second electrode exposed on the mounting surface of electronic component 2. Accordingly, both the first electrode and the second electrode exposed on the mounting surface of electronic component 2 are bonded by molten solder to first electrode 11 and second electrode 12 of support 1 exposed on first mounting surface 1a such that their outer contour shapes match. Accordingly, inclined mounting module 100 that is even more suitable for precise control of the mounting position of electronic component 2 can be obtained.

As illustrated in FIG. 6 and FIG. 7, circuit module 200 can be obtained by mounting inclined mounting module 100 on circuit board 3. That is, circuit module 200 includes inclined mounting module 100 and circuit board 3 on which support 1 in inclined mounting module 100 is mounted. FIG. 6 is a perspective view illustrating a portion of circuit module 200 according to Embodiment 1. FIG. 7 is a side view illustrating a portion of circuit module 200 according to Embodiment 1.

As illustrated in FIG. 6 and FIG. 7, in circuit module 200, support 1 of inclined mounting module 100 is mounted on circuit board 3 via second mounting surface 1b of support 1. Support 1 that supports electronic component 2 is mounted by disposing second mounting surface 1b of support 1 on circuit board 3. Thus, support 1 is a support member that is mounted on circuit board 3 while supporting electronic component 2.

Support 1 can be mounted on circuit board 3 by a mounting technique using a bonding material. Accordingly, although not illustrated, a bonding material is present between second mounting surface 1b of support 1 and circuit board 3. For example, solder can be used as the bonding material that bonds support 1 and circuit board 3. In this case, support 1 can be mounted on circuit board 3 by a soldering-based mounting technique using solder.

In the present embodiment, the bonding material used when support 1 is mounted on circuit board 3 and the bonding material used when electronic component 2 is mounted on support 1 are the same type of solder having substantially the same melting point. Specifically, the solder used when support 1 is mounted on circuit board 3 and the solder used when electronic component 2 is mounted on support 1 are the same.

At least one inclined mounting module 100 is mounted on circuit board 3. Circuit board 3 is an example of the board. Circuit board 3 is a mounting board used for mounting support 1. Circuit board 3 includes a first surface, which is a principal surface on which support 1 is mounted, and a second surface, which is a principal surface opposite to the first surface.

In the present embodiment, circuit board 3 is a printed wiring board on which electrodes 3a having a predetermined pattern (electrode pattern) are formed. Electrodes 3a are formed on the first surface of circuit board 3, which is one principal surface of circuit board 3. Note that circuit board 3 may be a double-sided wiring board having wiring formed on both surfaces. Circuit board 3 is, for example, a resin board having an electrically insulating resin material as the base material, a ceramic board having a ceramic material such as alumina as the base material, or a metal-based board having a metal material such as aluminum or copper as the base material. Note that circuit board 3 is a rigid board but may be a flexible board. In the present embodiment, the shape of circuit board 3 in a plan view is rectangular, but is not limited thereto. The shape of circuit board 3 in a plan view may be a polygon such as a rectangle, or may be circular, or may be another shape. The thickness of circuit board 3 is not particularly limited.

Since support 1 having electronic component 2 disposed thereon in an inclined orientation is mounted on circuit board 3, electronic component 2 is inclined relative to the principal surface of circuit board 3. Therefore, circuit module 200 is a module in which electronic component 2 is mounted on first mounting surface 1a inclined relative to second mounting surface 1b via which support 1 is mounted on circuit board 3.

Accordingly, when electronic component 2 has an active characteristic, it is possible to implement circuit module 200 capable of utilizing the active characteristic in an oblique direction relative to the principal surface of circuit board 3. When electronic component 2 has a passive characteristic, it is possible to implement circuit module 200 capable of receiving, by electronic component 2, physical properties arriving from an oblique direction relative to the principal surface of circuit board 3.

For example, when electronic component 2 is a solid-state light-emitting element, circuit module 200 having an active function suitable for outputting light in an oblique direction relative to the principal surface (mounting surface) of circuit board 3 can be obtained. When electronic component 2 is a detection element, circuit module 200 having a passive function suitable for detecting physical properties arriving from an oblique direction relative to the principal surface (mounting surface) of circuit board 3 can be obtained.

Thus, according to circuit module 200 of the present embodiment, it is possible to achieve favorable efficiency in: utilizing the active characteristic of electronic component 2 in an oblique direction relative to the principal surface of circuit board 3; or utilizing the passive characteristic of electronic component 2 with respect to physical properties arriving from an oblique direction relative to the principal surface of circuit board 3.

As described above, in support 1, first electrode 11 and second electrode 12 are exposed on each of first mounting surface 1a and second mounting surface 1b. Accordingly, heat generated by electronic component 2 mounted on first mounting surface 1a of support 1 is conducted by first electrode 11 and second electrode 12 and efficiently transmitted to circuit board 3 via second mounting surface 1b of support 1. Thus, first electrode 11 and second electrode 12, which are metal structures having a height with respect to circuit board 3, are structures that also serve as the positive and negative electrodes of electronic component 2 and can be used as heat conduction paths in a direction perpendicular to the principal surface of circuit board 3. This facilitates heat dissipation design using a metal structure having a height, and performance degradation due to temperature rise of incline-mounted electronic component 2 can be suppressed while achieving high-density mounting. That is, according to support 1 of the present embodiment, it is possible to effectively suppress performance degradation caused by high-density mounting of electronic component 2 that is incline-mounted.

Next, an example of a method for manufacturing circuit module 200 illustrated in FIG. 6 and FIG. 7 will be described with reference to FIG. 8. FIG. 8 is a diagram for describing an example of a method for manufacturing circuit module 200 according to Embodiment 1.

The method for manufacturing circuit module 200 illustrated in FIG. 8 includes a first placing process illustrated in (a) of FIG. 8, a second placing process illustrated in (b) of FIG. 8, and a mounting process illustrated in (c) of FIG. 8.

As illustrated in (a) of FIG. 8, in the first placing process, electronic component 2 is placed on first mounting surface 1a of support 1 via a first mounting material (not illustrated). The first mounting material is a bonding material that bonds support 1 and electronic component 2. In the present embodiment, the first mounting material is solder. As solder, a lead-free solder paste (product number: SN97C P603 D4, composition: 96.5%Sn-3%Ag-0.5%Cu, Nippon Superior Co., Ltd.) can be used, for example. This solder paste can be used likewise as the solder described below. Note that the solder paste is usually applied only to the metal portions (first electrode 11, second electrode 12) of first mounting surface 1a of support 1.

In the first placing process, solder paste is applied to first mounting surface 1a of support 1 by a dispenser device, and electronic component 2 is placed on the solder paste. When electronic component 2 is a white LED package, the white LED package is placed on support 1 such that the positive electrode and the negative electrode of the white LED package align with first electrode 11 and second electrode 12 of support 1. At this time, electronic component 2 is placed on support 1 such that electronic component 2 abuts receiving portion 20 of support 1. Specifically, side surface 2b of electronic component 2 abuts receiving surface 20a of receiving portion 20.

As illustrated in (b) of FIG. 8, in the second placing process, support 1 is placed on electrodes 3a of circuit board 3 via a second mounting material (not illustrated). The second mounting material is a bonding material that bonds support 1 and circuit board 3. In the present embodiment, the second mounting material is solder. The solder used in the second placing process is the same as the solder used in the first placing process.

In the second placing process, solder paste is applied onto electrodes 3a of circuit board 3 by a dispenser device, a suction nozzle is attached to suction portion 30 of support 1 by suction, and support 1 is placed on the solder paste.

As illustrated in (c) of FIG. 8, in the mounting process, electronic component 2 is mounted on support 1 using the first mounting material that bonds support 1 and electronic component 2, and support 1 is mounted on circuit board 3 using the second mounting material that bonds support 1 and circuit board 3.

Specifically, a structural body in which electronic component 2 is placed on support 1 via solder paste and support 1 is placed on circuit board 3 via solder paste is introduced into a reflow apparatus and heated under a temperature condition at which the solder paste melts, thereby melting the solder paste, and thereafter, the solder paste is solidified. By doing so, electronic component 2 can be bonded to first mounting surface 1a of support 1 via solder, and support 1 can be bonded via solder to circuit board 3 via second mounting surface 1b. Accordingly, first electrode 11 and second electrode 12 of support 1 are bonded to the positive electrode and the negative electrode of electronic component 2 that is a white LED package, and first electrode 11 and second electrode 12 of support 1 are bonded to a pair of electrodes 3a of circuit board 3.

The mounting process illustrated in (c) of FIG. 8 is performed after the first placing process illustrated in (a) of FIG. 8 and the second placing process illustrated in (b) of FIG. 8. In this case, the order of the first placing process and the second placing process is not particularly limited. For example, although the second placing process is performed after the first placing process in the present embodiment, the first placing process may be performed after the second placing process, or the first placing process and the second placing process may be performed simultaneously. That is, support 1 having electronic component 2 placed thereon via solder (the first mounting material) may be placed on circuit board 3 via solder (the second mounting material); electronic component 2 may be placed, via solder (the first mounting material), on support 1 that has been placed on circuit board 3 via solder (the second mounting material); or the placement of electronic component 2 via solder (the first mounting material) and the placement of support 1 on circuit board 3 via solder (the second mounting material) may be performed simultaneously.

In the mounting process illustrated in (c) of FIG. 8, not only does the solder (the second mounting material) between circuit board 3 and support 1 melt, but the solder (the first mounting material) between electronic component 2 and support 1 also melts. At this time, although electronic component 2 placed on first mounting surface 1a that is inclined could slide down in the direction in which the distance between first mounting surface 1a and second mounting surface 1b decreases (that is, toward the lower side of first mounting surface 1a), electronic component 2 does not slide down first mounting surface 1a because electronic component 2 abuts receiving portion 20 of support 1. Accordingly, it is possible to prevent positional displacement of electronic component 2 that occurs if electronic component 2 placed on first mounting surface 1a that is inclined slides down along first mounting surface 1a.

As a result, electronic component 2 can be mounted on support 1 and support 1 can be mounted on circuit board 3 while electronic component 2 is in the inclined state, without electronic component 2 placed on first mounting surface 1a of support 1 being displaced from its predetermined position. Thus, according to the method for manufacturing circuit module 200 in the present embodiment, circuit module 200 can be manufactured by a simple process.

According to the manufacturing method illustrated in FIG. 8, it is possible to fabricate circuit module 200 in which electronic component 2 is incline-mounted on circuit board 3, by simply introducing, into the reflow apparatus once, circuit board 3 on which support 1 supporting electronic component 2 has been placed.

Note that in FIG. 8, circuit module 200 is manufactured by mounting electronic component 2 on support 1 and mounting support 1 on circuit board 3 in a single mounting process; however, the present disclosure is not limited thereto. That is, circuit module 200 may be manufactured by separately performing the process of mounting electronic component 2 on support 1 and the process of mounting support 1 on circuit board 3. This manufacturing method will be described with reference to FIG. 9. FIG. 9 is a diagram for describing another example of the method for manufacturing circuit module 200 according to Embodiment 1.

The method for manufacturing circuit module 200 illustrated in FIG. 9 includes a first mounting process illustrated in (a) of FIG. 9, an inclining process illustrated in (b) of FIG. 9, and a second mounting process illustrated in (c) of FIG. 9.

As illustrated in (a) of FIG. 9, in the first mounting process, electronic component 2 is mounted on first mounting surface 1a of support 1. Specifically, in the first mounting process, solder paste is applied to first mounting surface 1a of support 1 that has been disposed so as to make first mounting surface 1a horizontal (parallel to the XY plane), and then electronic component 2 is placed on the solder paste. At this time, electronic component 2 is placed on support 1 such that electronic component 2 abuts receiving portion 20 of support 1. Specifically, side surface 2b of electronic component 2 abuts receiving surface 20a of receiving portion 20. Then, support 1 on which electronic component 2 has been placed via the solder paste is introduced into the reflow apparatus to melt the solder paste, and thereafter the solder paste is solidified. By doing so, electronic component 2 can be bonded to first mounting surface 1a of support 1 via solder.

As illustrated in (b) of FIG. 9, in the inclining process, support 1 having electronic component 2 mounted thereon is inclined. Specifically, support 1 is inclined by rotating support 1 having electronic component 2 mounted thereon so as to make second mounting surface 1b horizontal (parallel to the XY plane).

As illustrated in (c) of FIG. 9, in the second mounting process, support 1 having electronic component 2 mounted thereon is mounted on electrodes 3a of circuit board 3 via second mounting surface 1b. Specifically, in the second mounting process, solder paste is applied onto electrodes 3a of circuit board 3 that is disposed so as to make the principal surface horizontal (parallel to the XY plane), a suction nozzle is attached by suction to suction portion 30 of support 1 having electronic component 2 mounted thereon, support 1 having electronic component 2 mounted thereon is placed on the solder paste, circuit board 3 on which support 1 having electronic component 2 mounted thereon has been placed is introduced into the reflow apparatus to melt the solder paste, and thereafter the solder paste is solidified. By doing so, support 1 that supports electronic component 2 can be bonded to electrodes 3a of circuit board 3 via solder. Note that the solder used in the second mounting process is the same as the solder used in the first mounting process.

In the method for manufacturing circuit module 200 according to the present embodiment, the inclining process is performed after the first mounting process, and the second mounting process is performed after the inclining process. That is, the inclining process is performed between the first mounting process and the second mounting process.

A first mounting direction in which electronic component 2 is mounted on support 1 in the first mounting process (the direction of arrow A in (a) of FIG. 9) and a second mounting direction in which support 1 is mounted on electrodes 3a of circuit board 3 in the second mounting process (the direction of arrow B in (c) of FIG. 9) are the same direction. In the present embodiment, the first mounting direction (the direction of arrow A) and the second mounting direction (the direction of arrow B) are the direction of gravity (Z-axis direction).

In the second mounting process illustrated in (c) of FIG. 9, not only does the solder (the second mounting material) between circuit board 3 and support 1 melt, but the solder (the first mounting material) between electronic component 2 and support 1 also melts. At this time, although electronic component 2 placed on first mounting surface 1a that is inclined could slide down in the direction in which the distance between first mounting surface 1a and second mounting surface 1b decreases (that is, toward the lower side of first mounting surface 1a), electronic component 2 does not slide down first mounting surface 1a because electronic component 2 abuts receiving portion 20 of support 1. Accordingly, it is possible to prevent positional displacement of electronic component 2 that occurs if electronic component 2 placed on first mounting surface 1a that is inclined slides down along first mounting surface 1a. That is, the mounting position of electronic component 2 mounted on support 1 in the first mounting process remains substantially unchanged. Therefore, it is possible to mount electronic component 2 on support 1 and mount support 1 on circuit board 3 using the same type of mounting machine and with a minimum number of mounting flows, without changing the type of solder and the reflow temperature.

Thus, in the method for manufacturing circuit module 200 illustrated in FIG. 9, electronic component 2 can be mounted on support 1 and support 1 can be mounted on circuit board 3 while electronic component 2 is in the inclined state, without electronic component 2 placed on first mounting surface 1a of support 1 being displaced from its predetermined position. Therefore, even by the method for manufacturing circuit module 200 illustrated in FIG. 9, circuit module 200 can be manufactured by a simple process.

Note that the envelope volume of circuit module 200 according to the present embodiment is, for example, at least 1 cm³ and at most 1 m³, preferably at least 3 cm³ and at most 30000 cm³, and more preferably at least 1000 cm³ and at most 10000 cm³. By imparting such an envelope volume to circuit module 200, circuit module 200 becomes suitable for configuring an LED illumination device or a detection device, for example.

Also, in circuit module 200 illustrated in FIG. 6 and FIG. 7, one inclined mounting module 100 is disposed on one circuit board 3; however, the present disclosure is not limited thereto. Specifically, as in circuit module 201 illustrated in FIG. 10, a plurality of inclined mounting modules 100 may be disposed on one circuit board 3. In this case, as illustrated in FIG. 10, a plurality of the same inclined mounting modules 100 may be mounted on circuit board 3. Note that electrodes 3a of circuit board 3 are omitted in FIG. 10. The same applies hereinafter.

Further, in circuit module 201 illustrated in FIG. 10, inclined mounting modules 100 are mounted such that first mounting surfaces 1a (inclined surfaces) of supports 1 are oriented in the same direction and that the mounting density is uniform. By doing so, the plurality of electronic components 2 mounted on the plurality of supports 1 are oriented in one direction; therefore, circuit module 201 suitable for providing an active or passive characteristic with high directivity can be obtained.

Note that FIG. 10 illustrates a case in which inclined mounting modules 100 are mounted at intersections of a grid. With this configuration, the front of electronic components 2 obliquely mounted on supports 1 tends to be blocked by inclined mounting modules 100 mounted in a preceding row. To avoid this adverse effect, inclined mounting modules 100 may be disposed at intersections of an oblique grid. By doing so, inclined mounting modules 100 in the preceding row are mounted at positions offset from the front of electronic components 2 obliquely mounted on supports 1; therefore, inclined mounting modules 100 located two rows ahead are disposed in front. As a result, a space can be secured in front of each of incline-mounted electronic components 2, thus achieving both high-density mounting and an active or passive characteristic with high directivity.

FIG. 10 illustrates a case where inclined mounting modules 100 are mounted in a planar arrangement; however, depending on the application, inclined mounting modules 100 may be mounted in a linear arrangement. In this case, first mounting surfaces 1a of supports 1 may be arranged in a single column or in a single row. At this time, the directions of output light emitted from the plurality of inclined mounting modules 100 mounted on circuit board 3 may be the same or different. Further, inclined mounting modules 100 may be disposed so as to emit output light in a regular pattern in two or more different directions. In this case, the two or more different directions may be directions having different inclination angles relative to the board surface of circuit board 3, or directions having different rotation angles on the board surface of circuit board 3. Multiple variations are possible. For example, inclined mounting modules 100 may be disposed such that the inclination angles or rotation angles alternately differ.

Also, in circuit module 202 illustrated in FIG. 11, as in circuit module 201 illustrated in FIG. 10, a plurality of the same inclined mounting modules 100 are mounted on one circuit board 3, but first mounting surfaces 1a (inclined surfaces) of supports 1 in the respective inclined mounting modules 100 face different directions. Specifically, inclined mounting modules 100 are disposed such that first mounting surfaces 1a of supports 1 face the outer peripheral edge of circuit board 3. Further, in circuit module 202 illustrated in FIG. 11, a plurality of electronic components 2 that are not incline-mounted are disposed in the central portion of circuit board 3. That is, a plurality of electronic components 2 that are incline-mounted and a plurality of electronic components 2 that are not incline-mounted coexist. Note that the plurality of inclined mounting modules 100 and the plurality of electronic components 2 that are not incline-mounted are mounted on circuit board 3 such that the overall mounting density is uniform.

In circuit module 203 illustrated in FIG. 12, circular plate-shaped circuit board 3A is used, and a plurality of inclined mounting modules 100 and electronic component 2 that is not incline-mounted are both mounted on this circuit board 3A. The plurality of inclined mounting modules 100 are disposed such that first mounting surfaces 1a (inclined surfaces) of supports 1 face the outer peripheral edge of circuit board 3A. Electronic component 2 is disposed in the central portion of circuit board 3A and is surrounded by the plurality of inclined mounting modules 100. Note that the plurality of inclined mounting modules 100 and electronic component 2 that is not incline-mounted are mounted on circuit board 3A in a manner that the overall mounting density is uniform.

According to circuit module 203 illustrated in FIG. 12, when all electronic components 2 are solid-state light-emitting elements, it is possible to efficiently illuminate both the direction perpendicular to the principal surface (mounting surface) of circuit board 3A and the obliquely upward directions relative to the outer peripheral portion of circuit board 3A. Accordingly, circuit module 203 functioning as a surface light source that can emit intense output light in oblique directions can be obtained without disposing optical components such as lenses or reflectors, thus enabling resource saving and miniaturization of lighting fixtures.

When all electronic components 2 in circuit module 203 illustrated in FIG. 12 are detection elements, it is possible to implement circuit module 203 capable of simultaneously detecting physical properties (such as light) incident from the direction perpendicular to the principal surface (mounting surface) of circuit board 3A and from the obliquely upward directions relative to the outer peripheral portion of circuit board 3A. Accordingly, circuit module 203 capable of monitoring the physical properties over 360 degrees can be obtained.

Also, in circuit module 204 illustrated in FIG. 13 and FIG. 14, a plurality of inclined mounting modules whose first mounting surfaces 1a (inclined surfaces) have different inclination angles are mounted on circuit board 3. Specifically, as illustrated in FIG. 13 through FIG. 15, circuit module 204 includes: inclined mounting modules 100 (first inclined mounting modules) each having support 1 according to Embodiment 1; inclined mounting modules 100A (second inclined mounting modules) each having support 1A whose first mounting surface 1a is larger in inclination angle than that of support 1; and inclined mounting modules 100B (third inclined mounting modules) each having support 1B whose first mounting surface 1a is smaller in inclination angle than that of support 1.

A plurality of inclined mounting modules 100, a plurality of inclined mounting modules 100A, and a plurality of inclined mounting modules 100B are mounted, and the plurality of inclined mounting modules 100, 100A, and 100B are disposed such that their first mounting surfaces 1a (inclined surfaces) of the same group of inclined mounting modules face the same straight line. Also, inclined mounting modules 100, 100A, and 100B are each mounted such that the larger the inclination angle of first mounting surface 1a, the larger the non-mounting space in front of it. Specifically, the non-mounting space in front of each of inclined mounting modules 100A is larger than the non-mounting space in front of each of inclined mounting modules 100, and the non-mounting space in front of each of inclined mounting modules 100 is larger than the non-mounting space in front of each of inclined mounting modules 100B.

According to circuit module 204 illustrated in FIG. 13 and FIG. 14, when electronic components 2 are solid-state light-emitting elements, physical properties (such as light) can be emitted toward the same straight line. Also, when electronic components 2 are detection elements, physical properties (such as light) emitted from the same straight line can be detected. Accordingly, it is possible to implement circuit module 204 that is compact and features high-density mounting.

Note that in FIG. 13, inclined mounting modules 100, 100A, and 100B are disposed in a manner that first mounting surfaces 1a (inclined surfaces) of the same group of inclined mounting modules face the same straight line; however, the present disclosure is not limited thereto. For example, inclined mounting modules 100, 100A, and 100B may be disposed in a manner that first mounting surfaces 1a of the same group of inclined mounting modules face the same single point.

Further, in circuit module 205 illustrated in FIG. 16, a plurality of inclined mounting modules whose first mounting surfaces 1a (inclined surfaces) have different surface areas are mounted on circuit board 3. Specifically, as illustrated in FIG. 16, circuit module 205 includes: inclined mounting module 100 including support 1 according to Embodiment 1 (first inclined mounting module); and inclined mounting modules 100C (fourth inclined mounting modules) each including support 1C whose first mounting surface 1a is larger than first mounting surface 1a of support 1 in surface area. In the present variation, a plurality of inclined mounting modules 100C are mounted. In this case, a plurality of types of inclined mounting modules 100C whose first mounting surfaces 1a have different surface areas are mounted. A plurality of electronic components 2 are mounted on one support 1C included in each inclined mounting module 100C. Specifically, the following inclined mounting modules 100C are included: inclined mounting modules 100C in each of which two electronic components 2 are mounted on support 1C; inclined mounting module 100C in which three electronic components 2 are mounted on support 1C; and inclined mounting module 100C in which four electronic components 2 are mounted on support 1C. Each inclined mounting module 100C includes a plurality of first electrodes 11 and a plurality of second electrodes 12 corresponding to the plurality of electronic components 2. Note that, in the present variation, the inclination angle of first mounting surface 1a of support 1 in inclined mounting module 100 and the inclination angle of first mounting surface 1a of support 1C in each inclined mounting module 100C are the same, but may be different.

According to circuit module 205 illustrated in FIG. 16, a plurality of electronic components 2 are mounted per inclined mounting module 100C; therefore, the number of times mounting is performed for inclined mounting module 100 can be reduced. Also, since the mounting distribution of inclined mounting modules 100C on circuit board 3 can be readily designed according to the application, it is possible to implement circuit module 205 having excellent industrial producibility and responsiveness to customer requests.

Generally, circuit board 3 is made of a resin material having an electrically insulating property from the viewpoint of preventing electrical short circuits of electronic components 2; however, since resin materials generally have lower thermal conductivity than metal materials, designing heat dissipation for heat-generating electronic components 2 tends to be challenging. Meanwhile, circuit board 3 is in the shape of a flat plate in general, so if a plurality of electronic components 2 are mounted on circuit board 3, heat is not readily conducted in the direction along the horizontal plane of the principal surface of circuit board 3, thus imposing constraints on how close electronic components 2 can be placed. To address this, inclined mounting module 100 in the present embodiment includes support 1 capable of achieving both high-density mounting and suppression of performance degradation caused by temperature rise of incline-mounted electronic components 2; therefore, inclined mounting module 100 is advantageous for high-density mounting. For example, the mounting density of electronic components 2 can be greater than one component/cm², and further can be greater than three components/cm². Accordingly, since electronic components 2 can be mounted at high density, circuit module 205 that is compact and enables miniaturization of electronic devices can be obtained.

Note that in the circuit modules illustrated in FIG. 10 through FIG. 16, the plurality of electronic components 2 are all the same; however, the present disclosure is not limited thereto. For example, the circuit modules illustrated in FIG. 10 through FIG. 16 may include both inclined mounting modules in which electronic components 2 are solid-state light-emitting elements and inclined mounting modules in which electronic components 2 are detection elements. Also, in the circuit modules illustrated in FIG. 10 through FIG. 16, the mounting density of inclined mounting modules and electronic components 2 can be high or low according to the application or customer requests. Further, inclined mounting modules and electronic components 2 may be mounted in a manner that their in-plane distributions within the principal surface of the circuit board are uniform or non-uniform.

Next, electronic device 300 according to the present embodiment will be described with reference to FIG. 17. FIG. 17 is a perspective view of electronic device 300 according to Embodiment 1.

As illustrated in FIG. 17, electronic device 300 according to the present embodiment includes circuit module 201 illustrated in FIG. 10. Circuit module 201 includes a plurality of inclined mounting modules 100 mounted on circuit board 3. Thus, electronic device 300 includes inclined mounting modules 100.

With this configuration, electronic device 300 including electronic components 2 that are mounted at an angle relative to the principal surface of circuit board 3 can be obtained. Accordingly, it is possible to implement electronic device 300 having favorable efficiency in: utilizing the active characteristics of electronic components 2 in an oblique direction relative to the principal surface of circuit board 3; and utilizing the passive characteristics of electronic components 2 with respect to physical properties arriving from an oblique direction relative to the principal surface of circuit board 3.

For example, electronic device 300 illustrated in FIG. 17 is an illumination device in which electronic components 2 are solid-state light-emitting elements (for example, LEDs or semiconductor lasers). Circuit module 201 is fixed to base 4 that serves as a heat sink. Circuit module 201 may include a lighting circuit (not illustrated) for the solid-state light-emitting elements. Note that, although not illustrated, electronic device 300 includes a light-transmissive cover that covers circuit module 201. Electric power is supplied to circuit module 201 via power feeding line 5. This enables electronic components 2 (solid-state light-emitting elements) to emit light. Note that electronic device 300 includes mounting brackets 6 for fixing electronic device 300 to a building.

In electronic device 300 configured as described above, since electronic components 2 of circuit module 201 that serve as solid-state light-emitting elements are mounted at an angle relative to the principal surface of circuit board 3, electronic components 2 serving as solid-state light-emitting elements emit light in an oblique direction relative to the principal surface of circuit board 3. This light is the illumination light of electronic device 300 serving as an illumination device. Thus, an illumination device capable of emitting intense illumination light in an oblique direction can be implemented.

Further, another example of electronic device 300 according to the present embodiment will be described with reference to FIG. 18. FIG. 18 is a schematic view of electronic device 300X in another example according to Embodiment 1.

Electronic device 300X illustrated in FIG. 18 is a detection device or an evaluation device in which a solid-state light-emitting element and a light detection element are combined as electronic components. Specifically, electronic device 300X includes: inclined mounting module 100 (first inclined mounting module) in which electronic component 2 mounted on support 1 is a solid-state light-emitting element; inclined mounting module 100X (second inclined mounting module) in which electronic component 2X mounted on support 1 is a light detection element; and housing 7 that accommodates inclined mounting modules 100 and 100X. In housing 7, substance 8 is present between electronic component 2 (solid-state light-emitting element) and electronic component 2X (light detection element). Substance 8 is at least one substance selected from a gas, a liquid, and a solid, for example.

In electronic device 300X illustrated in FIG. 18, light emitted from electronic component 2 (solid-state light-emitting element) is received by electronic component 2X (light detection element) via substance 8 and converted into an electrical signal. At this time, electronic component 2X (light detection element) detects: light resulting from scattering, by substance 8, of light emitted from electronic component 2 (solid-state light-emitting element); or light resulting from absorption, by substance 8, of at least part of light emitted from electronic component 2 (solid-state light-emitting element). Thus, by analyzing or parsing the light detected by electronic component 2X (light detection element), it is possible to detect the presence of substance 8 or evaluate the state or the like of substance 8.

### [Embodiment 2]

Next, support 1F according to Embodiment 2 will be described with reference to FIG. 19. FIG. 19 is a perspective view of support 1F according to Embodiment 2.

As illustrated in FIG. 19, support 1F according to the present embodiment is configured such that insulator 13 of support 1 according to Embodiment 1 is divided into first insulator 13a and second insulator 13b and that fixing body 16 is further included.

Since support 1F includes fixing body 16, mechanical strength of support 1F against vibration can be readily ensured. Fixing body 16 is disposed between first insulator 13a and second insulator 13b. In the present embodiment, fixing body 16 also serves as a heat-dissipating body. That is, fixing body 16 has not only the function of ensuring mechanical strength of support 1F but also the function of dissipating heat generated by electronic component 2 (not illustrated) mounted on support 1F. Therefore, fixing body 16 may be made of a metal material in view of both mounting electronic component 2 on support 1F and dissipating heat generated by electronic component 2. Fixing body 16 is, for example, a plate-shaped metal block made of a metal material having high thermal conductivity such as copper or aluminum. Specifically, fixing body 16 is a flat plate-shaped metal block having a constant thickness.

Note that the shape of fixing body 16 is not limited to this and may be mesh-shaped. By making fixing body 16 a mesh-shaped metal member, a mesh surface where the proportion of hard metal portions is reduced is formed; therefore, fixing body 16 can be readily fabricated by punching out a predetermined shape.

In the present embodiment as well, support 1F includes first electrode 11, second electrode 12, first protector 14, and second protector 15. First insulator 13a is disposed between fixing body 16 and first electrode 11. Second insulator 13b is disposed between fixing body 16 and second electrode 12.

When support 1F is viewed from a side (Y-axis direction), projection views (side views) of first electrode 11 and second electrode 12 may be the same in shape. Accordingly, first electrode 11 and second electrode 12 can each be fabricated by performing punching processing on a metal plate. Thus, it is possible to implement support 1F having excellent industrial producibility. Note that, in the present embodiment, first electrode 11 and second electrode 12 are the same in shape and size.

Further, as in Embodiment 1, first protector 14 covers a side surface of first electrode 11, and second protector 15 covers a side surface of second electrode 12. Note that first protector 14 and second protector 15 according to the present embodiment are thicker than first protector 14 and second protector 15 according to Embodiment 1.

As in support 1 according to Embodiment 1, support 1F includes first mounting surface 1a and second mounting surface 1b. Not only first electrode 11, second electrode 12, insulator 13 (first insulator 13a, second insulator 13b), first protector 14, and second protector 15 but also fixing body 16 are exposed on each of first mounting surface 1a and second mounting surface 1b. Therefore, heat generated by electronic component 2 mounted on first mounting surface 1a is conducted from first mounting surface 1a to second mounting surface 1b not only via first electrode 11 and second electrode 12 but also via fixing body 16. Accordingly, heat generated by electronic component 2 mounted on first mounting surface 1a can be efficiently dissipated.

In the present embodiment, first insulator 13a, second insulator 13b, first protector 14, and second protector 15 are integrally configured. Specifically, first insulator 13a, second insulator 13b, first protector 14, and second protector 15 are integrally molded from a resin material into a resin molded article.

First electrode 11, second electrode 12, and fixing body 16, which are metal members, are embedded in the resin forming first insulator 13a, second insulator 13b, first protector 14, and second protector 15. Accordingly, it is possible to not only readily ensure electrical insulation between first electrode 11 and second electrode 12, but also fabricate support 1F by insert molding. Specifically, first electrode 11, second electrode 12, and fixing body 16, which are metal members, are set in a mold, and resin is injected into the mold and solidified, so that these metal members are embedded and fixed in the resin, allowing support 1F to be fabricated. Accordingly, support 1F having excellent electrical reliability and industrial producibility can be obtained.

As in support 1 according to Embodiment 1, support 1F configured as described above includes receiving portion 20 that receives electronic component 2 mounted on first mounting surface 1a that is inclined. Accordingly, as in support 1 according to Embodiment 1, it is possible to prevent positional displacement of electronic component 2 that occurs if electronic component 2 slides down along first mounting surface 1a when support 1F having electronic component 2 disposed thereon is mounted on a board such as circuit board 3. Note that, in the present embodiment, receiving portion 20 is part of the resin molded article constituted by first insulator 13a, second insulator 13b, first protector 14, and second protector 15. Therefore, although receiving portion 20 according to Embodiment 1 is partially first electrode 11 and second electrode 12, receiving portion 20 according to the present embodiment does not include first electrode 11 or second electrode 12.

Note that, as in support 1 according to Embodiment 1, support 1F includes suction portion 30 to which a suction nozzle is to be attached by suction. Accordingly, as in support 1 according to Embodiment 1, support 1F can be readily picked up by the suction nozzle.

With support 1F configured as described above, an inclined mounting module can be obtained by mounting electronic component 2 on first mounting surface 1a of support 1F as in Embodiment 1. Further, a circuit module can be obtained by mounting, on circuit board 3, support 1F having electronic component 2 mounted thereon.

In this case, as in circuit module 206 illustrated in FIG. 20, for example, a plurality of inclined mounting modules whose first mounting surfaces 1a have different surface areas may be mounted on circuit board 3. Specifically, as illustrated in FIG. 20, circuit module 206 includes: inclined mounting module 100F in which one electronic component 2 is mounted on support 1F; and inclined mounting modules 100F' each including support 1F' whose first mounting surface 1a is larger than first mounting surface 1a of support 1F in surface area. In the present variation, a plurality of inclined mounting modules 100F' are mounted. In this case, a plurality of types of inclined mounting modules 100F' whose first mounting surfaces 1a have different surface areas are mounted. A plurality of electronic components 2 are mounted on one support 1F' in each inclined mounting module 100F'.

### [Embodiment 3]

Next, support 1G according to Embodiment 3 will be described with reference to FIG. 21. FIG. 21 is a perspective view of support 1G according to Embodiment 3.

As illustrated in FIG. 21, support 1G according to the present embodiment includes, as in Embodiment 2, first electrode 11, second electrode 12, first insulator 13a, second insulator 13b, first protector 14, second protector 15, and fixing body 16 that also serves as a heat-dissipating body.

As in support 1F according to Embodiment 2, support 1G includes first mounting surface 1a and second mounting surface 1b. As in Embodiment 2, not only first electrode 11, second electrode 12, insulator 13 (first insulator 13a, second insulator 13b), first protector 14, and second protector 15 but also fixing body 16 are exposed on each of first mounting surface 1a and second mounting surface 1b.

Note that, unlike Embodiment 2, first insulator 13a, second insulator 13b, first protector 14, and second protector 15 according to the present embodiment are not integrally configured. That is, first electrode 11, second electrode 12, first insulator 13a, second insulator 13b, first protector 14, second protector 15, and fixing body 16 are each a separate plate-shaped member and constitute a layered structure. Note that these members are bonded to one another.

With this configuration, sufficient electrical insulation can be ensured between first electrode 11 and second electrode 12; therefore, support 1G having electrical reliability can be obtained. Moreover, since first electrode 11 and second electrode 12 have height and thickness, first electrode 11 and second electrode 12 have a large envelope volume. Accordingly, heat generated by electronic component 2 mounted on first mounting surface 1a of support 1G can be efficiently transmitted to second mounting surface 1b and further to circuit board 3.

As in support 1 according to Embodiment 1, support 1G includes receiving portion 20 that receives electronic component 2 mounted on first mounting surface 1a that is inclined. Accordingly, as in support 1 according to Embodiment 1, it is possible to prevent positional displacement of electronic component 2 that occurs if electronic component 2 slides down along first mounting surface 1a when support 1G having electronic component 2 disposed thereon is mounted on a board such as circuit board 3.

Groove 40 is provided in support 1G according to the present embodiment. Groove 40 is formed at the boundary between first mounting surface 1a and receiving portion 20. Specifically, groove 40 is formed at the lower end of first mounting surface 1a. Groove 40 is formed in the Y-axis direction. Specifically, groove 40 is formed so as to penetrate support 1G in the Y-axis direction. At the time of mounting support 1G on circuit board 3 after electronic component 2 is mounted on first mounting surface 1a by soldering, the solder melts and excess molten solder may flow down first mounting surface 1a; however, by providing groove 40 in support 1G in the manner described above, the excess molten solder can flow into and accumulate in groove 40. In other words, groove 40 is a relief recess that allows molten solder to escape from first mounting surface 1a. This makes it possible to suppress to some extent electrical short-circuiting between first electrode 11 and second electrode 12 caused by molten solder flowing down first mounting surface 1a and spreading in the lateral direction of first mounting surface 1a. Further, molten solder that has flowed down first mounting surface 1a can be suppressed to some extent from protruding out of support 1G.

Note that, as in support 1 according to Embodiment 1, support 1G includes suction portion 30 to which a suction nozzle is to be attached by suction. Accordingly, as in support 1 according to Embodiment 1, support 1G can be readily picked up by the suction nozzle.

With support 1G configured as described above, an inclined mounting module can be obtained by mounting electronic component 2 on first mounting surface 1a of support 1G as in Embodiment 1. Further, a circuit module can be obtained by mounting, on circuit board 3, support 1G having electronic component 2 mounted thereon.

Note that, in the present embodiment, the shortest distance between receiving portion 20 and one of first electrode 11 or second electrode 12 may be less than one-third of the maximum length of first mounting surface 1a in the inclination direction of first mounting surface 1a that is inclined relative to second mounting surface 1b.

With this configuration, when solder melts and electronic component 2 slides down along the inclination of first mounting surface 1a, receiving portion 20 can reliably prevent movement of electronic component 2. Accordingly, it is possible to improve the accuracy in alignment of electronic component 2 at its predetermined mounting position.

### [Embodiment 4]

Next, support 1H according to Embodiment 4 will be described with reference to FIG. 22. FIG. 22 is a perspective view of support 1H according to Embodiment 4.

As illustrated in FIG. 22, support 1H according to the present embodiment includes first electrode 11, second electrode 12, and fixing body 16 as in support 1G according to Embodiment 3; however, unlike support 1G according to Embodiment 3, support 1H does not include insulator 13. That is, in support 1H according to the present embodiment, first electrode 11 and second electrode 12 are spaced apart from each other by a gap (air layer). First electrode 11, second electrode 12, and fixing body 16 may be fixed to a holding member not illustrated. Note that support 1H according to the present embodiment does not include first protector 14 or second protector 15, but may include first protector 14 and second protector 15.

As in support 1G according to Embodiment 3, support 1H includes first mounting surface 1a and second mounting surface 1b. First electrode 11, second electrode 12, and fixing body 16 are exposed on each of first mounting surface 1a and second mounting surface 1b.

As in support 1G according to Embodiment 3, support 1H includes receiving portion 20 that receives electronic component 2 mounted on first mounting surface 1a that is inclined. Accordingly, as in support 1G according to Embodiment 3, it is possible to prevent positional displacement of electronic component 2 that occurs if electronic component 2 slides down along first mounting surface 1a when support 1H having electronic component 2 disposed thereon is mounted on circuit board 3 or the like.

With support 1H configured as described above, an inclined mounting module can be obtained by mounting electronic component 2 on first mounting surface 1a of support 1H as in Embodiment 1. Further, a circuit module can be obtained by mounting, on circuit board 3, support 1H having electronic component 2 mounted thereon.

Note that in support 1H illustrated in FIG. 22, first electrode 11, second electrode 12, and fixing body 16 are plate-shaped metal blocks; however, the present disclosure is not limited thereto. For example, as in support 1I illustrated in FIG. 23, first electrode 11, second electrode 12, and fixing body 16 may be frame-shaped metal members in which portions of the electrodes are omitted.

### [Embodiment 5]

Next, support 1J according to Embodiment 5 will be described with reference to FIG. 24 through FIG. 29. FIG. 24 is a perspective view of support 1J according to Embodiment 5, and FIG. 25 is a diagram illustrating the configuration of support 1J. FIG. 26 is a perspective view of a plurality of metal blocks (first electrode 11, second electrode 12, fixing body 16) included in support 1J, and FIG. 27 is a diagram illustrating the configuration of the plurality of metal blocks. FIG. 28 is a perspective view of resin block 17 included in support 1J, and FIG. 29 is a diagram illustrating the configuration of resin block 17. In FIG. 25, FIG. 27, and FIG. 29, (a) is a side view and (b) is a top view.

As illustrated in FIG. 24 and FIG. 25, support 1J according to the present embodiment includes first electrode 11, second electrode 12, and fixing body 16 as in support 1G according to Embodiment 3. As illustrated in FIG. 26 and FIG. 27, first electrode 11, second electrode 12, and fixing body 16 are plate-shaped metal blocks. Specifically, first electrode 11, second electrode 12, and fixing body 16 are flat plate-shaped metal blocks each having a constant thickness.

First electrode 11, second electrode 12, and fixing body 16 can each be fabricated by machining a copper block using a router machine, for example. As one example, one first metal formed body serving as first electrode 11 or second electrode 12 has a width of 0.5 mm, a height of 3.5 mm, a depth of 4.35 mm, and a volume of 5.5 mm³. Also, a second metal formed body serving as fixing body 16 has a width of 1.3 mm, a height of 3.5 mm, a depth of 4.35 mm, and a volume of 14.5 mm³.

Further, as illustrated in FIG. 24 and FIG. 25, support 1J includes resin block 17 made of a resin material having an electrically insulating property. For example, epoxy resin can be used as the resin material forming resin block 17.

As illustrated in FIG. 28 and FIG. 29, resin block 17 includes: first insulating portion 17a (first resin portion) corresponding to first insulator 13a described above; second insulating portion 17b (second resin portion) corresponding to second insulator 13b described above; first protecting portion 17c (third resin portion) corresponding to first protector 14 described above; and second protecting portion 17d (fourth resin portion) corresponding to second protector 15 described above. First insulating portion 17a, second insulating portion 17b, first protecting portion 17c, and second protecting portion 17d are connected to one another.

Resin block 17 having the shape illustrated in FIG. 28 and FIG. 29 can be fabricated by machining an epoxy resin block using a router machine, for example. As one example, resin block 17 has a width of 4 mm, a height of 3.5 mm, a depth of 5.28 mm, and a volume of 24 mm³.

Support 1J can be fabricated by assembling resin block 17 and metal blocks (first electrode 11, second electrode 12, fixing body 16). For example, support 1J can be fabricated by assembling metal blocks into resin block 17. In this case, resin block 17 and metal blocks can be bonded using a bonding material. Note that support 1J according to the present embodiment can also be fabricated by insert molding.

As in support 1G according to Embodiment 3, support 1J includes first mounting surface 1a and second mounting surface 1b. First electrode 11, second electrode 12, fixing body 16, and resin block 17 are exposed on each of first mounting surface 1a and second mounting surface 1b.

As in support 1G according to Embodiment 3, support 1J includes receiving portion 20 that receives electronic component 2 mounted on first mounting surface 1a that is inclined. Accordingly, as in support 1G according to Embodiment 3, it is possible to prevent positional displacement of electronic component 2 that occurs if electronic component 2 slides down along first mounting surface 1a when support 1J having electronic component 2 disposed thereon is mounted on circuit board 3 or the like. In the present embodiment, receiving portion 20 is provided to resin block 17. Specifically, two receiving portions 20, which are protruding portions, are provided to resin block 17. Two resin blocks 17 are formed to be spaced apart from each other in the Y-axis direction and extend in the X-axis direction.

Recesses 50 are provided in support 1J according to the present embodiment. Recesses 50 are formed at the boundary between first mounting surface 1a and receiving portions 20. Specifically, recesses 50 are formed at the lower end of first mounting surface 1a. Three recesses 50 are formed. Specifically, the bottoms of recesses 50 are surfaces of first electrode 11, second electrode 12, and fixing body 16. At the time of mounting support 1J on circuit board 3 after electronic component 2 is mounted on first mounting surface 1a by soldering, the solder melts and excess molten solder may flow down first mounting surface 1a; however, by providing recesses 50 in support 1J in the manner described above, the excess molten solder can flow into and accumulate in recesses 50. In other words, recesses 50 are relief recesses that allow molten solder to escape. This makes it possible to suppress electrical short-circuiting between first electrode 11 and second electrode 12 caused by molten solder flowing down first mounting surface 1a and spreading in the lateral direction of first mounting surface 1a. Further, molten solder that has flowed down first mounting surface 1a can be suppressed from protruding out of support 1J.

Note that a partition wall is formed between two adjacent recesses 50 among three recesses 50. This partition wall separates at least recess 50 located on the lower side of the inclined surface of first electrode 11 and recess 50 located on the lower side of the inclined surface of second electrode 12. The partition wall is made of a nonmetal material. In the present embodiment, the partition wall is part of resin block 17 and is made of a resin material.

As in support 1G according to Embodiment 3, support 1J includes suction portion 30 to which a suction nozzle is to be attached by suction. Accordingly, as in support 1G according to Embodiment 3, support 1J can be readily picked up by the suction nozzle.

With support 1J configured as described above, an inclined mounting module can be obtained by mounting electronic component 2 on first mounting surface 1a of support 1J as in Embodiment 1. Further, a circuit module can be obtained by mounting, on circuit board 3, support 1J having electronic component 2 mounted thereon.

### [Embodiment 6]

Next, support 1K according to Embodiment 6 will be described with reference to FIG. 30. FIG. 30 is a perspective view of support 1K according to Embodiment 6.

As illustrated in FIG. 30, support 1K according to the present embodiment includes first electrode 11 and second electrode 12 as in support 1 according to Embodiment 1; however, unlike support 1 according to Embodiment 1, support 1K does not include insulator 13. That is, in support 1K according to the present embodiment, first electrode 11 and second electrode 12 are spaced apart from each other by a gap (air layer). First electrode 11 and second electrode 12 may be fixed to a holding member not illustrated. Note that support 1K according to the present embodiment does not include first protector 14 or second protector 15. Specifically, support 1K according to the present embodiment includes first electrode 11 and second electrode 12 only.

Although first electrode 11 and second electrode 12 according to Embodiment 1 are flat metal plates, first electrode 11 and second electrode 12 according to the present embodiment are bent metal plates. Note that electrodes (first electrode 11 and second electrode 12) having the bent shape illustrated in FIG. 30 can be formed also by punching out, in the Y direction, metal plates having a thickness. First electrode 11 and second electrode 12 of support 1K are the same in shape and size.

First electrode 11 and second electrode 12 having the shape illustrated in FIG. 30 can each be fabricated by bending an elongated metal plate. First electrode 11 and second electrode 12 can be readily fabricated by typical sheet-metal processing. Therefore, it is possible to obtain support 1K that has excellent industrial producibility and facilitates heat dissipation design. As one example, first electrode 11 and second electrode 12 can each be fabricated by bending a copper plate (1 mm thick, 3 mm wide, 19 mm long) by a machine tool or by hand.

As in support 1 according to Embodiment 1, support 1K includes first mounting surface 1a and second mounting surface 1b. First electrode 11 and second electrode 12 are each exposed on first mounting surface 1a and second mounting surface 1b. Specifically, first mounting surface 1a and second mounting surface 1b are formed on each of first electrode 11 and second electrode 12.

As in support 1 according to Embodiment 1, support 1K includes receiving portion 20 that receives electronic component 2 mounted on first mounting surface 1a that is inclined. Receiving portion 20 is provided on each of first electrode 11 and second electrode 12.

That is, first electrode 11 and second electrode 12 are each bent so as to include: an inclined surface serving as first mounting surface 1a; a bottom surface serving as second mounting surface 1b; and receiving portion 20. First electrode 11 and second electrode 12 are disposed in parallel with a gap therebetween such that first mounting surface 1a of first electrode 11 and first mounting surface 1a of second electrode 12 lie in a single plane and that second mounting surface 1b of first electrode 11 and second mounting surface 1b of second electrode 12 lie in a single plane. Accordingly, support 1K formed by a pair of first electrode 11 and second electrode 12 each having receiving portion 20 can be obtained.

As illustrated in FIG. 31, with support 1K configured as described above, inclined mounting module 100K can be obtained by mounting electronic component 2 on first mounting surfaces 1a of support 1K. At this time, since support 1K includes receiving portions 20, it is possible, as in Embodiment 1, to prevent positional displacement of electronic component 2 that occurs if electronic component 2 slides down along first mounting surfaces 1a when support 1K having electronic component 2 disposed thereon is mounted on circuit board 3 or the like. FIG. 31 is a diagram illustrating the configuration of inclined mounting module 100K according to Embodiment 6. In FIG. 31, (a) is a perspective view, (b) is a side view, and (c) is a top view.

Further, although not illustrated, a circuit module can be obtained by mounting support 1K on circuit board 3. For example, a circuit module can be obtained by: bonding, with solder, first electrode 11 and second electrode 12 to paired electrodes 3a that are formed on circuit board 3 with a predetermined gap (for example, 0.65 mm) therebetween; and mounting electronic component 2 on support 1K that is constituted by the pair of first electrode 11 and second electrode 12. In this case, first electrode 11 and second electrode 12 function as a pair of a positive electrode and a negative electrode that supply electric power from circuit board 3 to electronic component 2 mounted on first mounting surfaces 1a.

Note that, as illustrated in FIG. 32, part of the metal plate forming first electrode 11A (second electrode 12A) may be extended to provide suction portion 30 on part of first electrode 11A (second electrode 12A). That is, suction portion 30 may be formed at the portion forming the bottom of support 1K constituted by a pair of first electrode 11A and second electrode 12A. Accordingly, the plane serving as suction portion 30 is exposed from receiving portion 20 in the top view; therefore, first electrode 11A (second electrode 12A) can be readily picked up by a suction nozzle.

Further, when the support includes first electrode 11 and second electrode 12 only, the support may be support 1K' that includes first electrode 11 and second electrode 12 having the shape illustrated in FIG. 33. In support 1K' illustrated in FIG. 33, receiving portions 20 that receive electronic component 2 mounted on first mounting surfaces 1a that are inclined are formed by bending metal plates constituting first electrode 11 and second electrode 12.

### [Embodiment 7]

Next, support 1L according to Embodiment 7 will be described with reference to FIG. 34 and FIG. 35. FIG. 34 is a perspective view of support 1L according to Embodiment 7. FIG. 35 is a diagram illustrating the configuration of support 1L according to Embodiment 7. In FIG. 35, (a) is a side view, (b) is a top view, and (c) is a back view.

As illustrated in FIG. 34 and FIG. 35, support 1L includes first electrode 11 and second electrode 12. Support 1L according to the present embodiment includes base member 18, and first electrode 11 and second electrode 12 are thin metal films formed in a predetermined pattern on a surface of base member 18. Base member 18 includes inclined surface 18a having the same inclination angle as first mounting surface 1a, and first electrode 11 and second electrode 12 are formed on at least inclined surface 18a. In the present embodiment, first electrode 11 and second electrode 12 are formed from inclined surface 18a, which is the top surface of base member 18, to the rear surface of base member 18. In the present embodiment, the rear surface of base member 18 is the lower surface of support 1L.

Further, metal film 19 is formed on the surface of base member 18. Metal film 19 is formed between first electrode 11 and second electrode 12 so as to be spaced apart from first electrode 11 and second electrode 12. Metal film 19 can be used as a heat-dissipating member for dissipating heat generated by electronic component 2 or as a third electrode. Metal film 19 can be formed simultaneously with first electrode 11 and second electrode 12. Metal film 19 is also formed from inclined surface 18a, which is the top surface of base member 18, to the rear surface of base member 18.

Base member 18 includes, for example: a metal block made of a metal material such as aluminum or copper; and an electrically insulating film (not illustrated) that covers the entire metal block. An envelope volume of the metal block is, as one example, 48.3 cm³. The electrically insulating film covering the metal block is a resin film made of a resin material such as polyimide resin. The resin film can be formed by a dip-coating method. For example, by repeating a coating and drying step several times in which the metal block is dipped in a polyimide varnish and then dried using a heating dryer at 300 to 400 degrees Celsius for several hours, an electrically insulating film (resin coat film) made of polyimide resin having a thickness of approximately 20 µm can be formed over the entire surface of the metal block.

When base member 18 is a metal block covered with an electrically insulating film, first electrode 11 and second electrode 12 are formed on the electrically insulating film. For example, first electrode 11 and second electrode 12 can be formed by a plating technique in which gold and nickel are stacked. As one example, each of first electrode 11 and second electrode 12 has a thickness of 3.5 µm and a width of 0.5 mm. Further, each of first electrode 11 and second electrode 12 that are formed so as to span from inclined surface 18a of base member 18 to the rear surface of base member 18 has a length of 12 mm. Also, the layered structure of gold and nickel forming first electrode 11 and second electrode 12 is, for example, a three-layer structure (Au/Ni/Au) of a gold layer (0.5 µm), a nickel layer (3.0 µm) formed on the gold layer, and a gold layer (0.05 µm) formed on the nickel layer.

As in support 1 according to Embodiment 1, support 1L includes first mounting surface 1a and second mounting surface 1b. First electrode 11, second electrode 12, and metal film 19 are each exposed on first mounting surface 1a and second mounting surface 1b. Specifically, the surface of each of first electrode 11, second electrode 12, and metal film 19 is first mounting surface 1a and second mounting surface 1b.

As in support 1 according to Embodiment 1, support 1L includes receiving portion 20 that receives electronic component 2 mounted on first mounting surface 1a that is inclined. Accordingly, as in support 1 according to Embodiment 1, it is possible to prevent positional displacement of electronic component 2 that occurs if electronic component 2 slides down along first mounting surface 1a when support 1L having electronic component 2 disposed thereon is mounted on circuit board 3 or the like. In the present embodiment, receiving portion 20 is provided to base member 18.

Further, in the present embodiment, base member 18 of support 1L includes a metal block. Thus, when base member 18 is made of metal, support 1L having excellent thermal conductivity can be obtained.

Note that base member 18 is not limited to metal and may be made of resin. In this case, liquid crystal polymer (LCP), for example, can be used as the material of base member 18, and base member 18 made of resin (envelope volume 48.3 cm³) can be fabricated by typical injection molding technology. Further, after modifying surfaces of electrode-forming portions of inclined surface 18a and the rear surface of resin base member 18 by light irradiation, the same plating technique as described above is used, thereby forming first electrode 11 and second electrode 12 to span inclined surface 18a and the rear surface of base member 18. Thus, by making base member 18 from resin, support 1L can be fabricated at low cost.

### [Variations]

Although supports and the like according to the present invention have been described based on Embodiments 1 through 7, the present invention is not limited to Embodiments 1 through 7.

For example, when fabricating support 1G according to Embodiment 3, first electrode 11, second electrode 12, first insulator 13a, second insulator 13b, first protector 14, second protector 15, and fixing body 16 are separately fabricated and then bonded to one another; however, the present disclosure is not limited thereto. For example, support 1G can be fabricated by cutting out part of multilayer substrate 400 illustrated in FIG. 36 and FIG. 37. As illustrated in FIG. 37, multilayer substrate 400 has a layered structure of: metal layer 401; insulating layer 402, metal layer 403, and insulating layer 404 that are sequentially stacked on one surface of metal layer 401; and insulating layer 405, metal layer 406, and insulating layer 407 that are sequentially stacked on the other surface of metal layer 401. Metal layers 401, 403, and 406 are, for example, copper layers and correspond to fixed body 16, first electrode 11, and second electrode 12, respectively. Insulating layers 402, 404, 405, and 407 are, for example, resin layers such as prepreg (a carbon fiber sheet pre-impregnated with resin) or glass-epoxy base materials, and correspond to first insulator 13a, first protector 14, second insulator 13b, and second protector 15, respectively. By performing router machining on multilayer substrate 400 using a router machine, support 1G having the shape illustrated in FIG. 21 can be fabricated. Note that support 1G can also be produced by performing punching processing or the like on multilayer substrate 400 instead of router machining.

Further, in Embodiment 1 and the like, a surface-mount electronic component including a plurality of electrodes on the rear surface is used as electronic component 2. In this case, the electrodes of electronic component 2 have patterns illustrated in FIG. 38, for example. In FIG. 38, (a) illustrates an electrode pattern in which a pair of electrodes, namely a positive electrode and a negative electrode, have the same shape and the same size, (b) illustrates an electrode pattern in which a positive electrode and a negative electrode are different in size (in the diagram, the negative electrode is larger than the positive electrode), and (c) illustrates an electrode pattern in which a heat-dissipating electrode that dissipates heat is added between a positive electrode and a negative electrode.

When using such surface-mount electronic component 2, at least one of the paired electrodes provided on the rear surface of electronic component 2 may be configured such that the shape of the side facing the other electrode is linear, or the shape of the tip of a convex portion of the side facing the other electrode is linear. Similarly, at least one of first electrode 11 or second electrode 12 exposed on first mounting surface 1a may be configured such that, on first mounting surface 1a, the shape of the side facing the other electrode is linear, or the shape of the tip of a convex portion of the side facing the other electrode is linear. In another form, first and second electrodes 11 and 12 and the pair of electrodes of electronic component 2 may both be configured as described above.

By configuring first electrode 11 and second electrode 12 or the pair of electrodes of electronic component 2 in such a manner, solder that melts and solidifies acts to align the linear electrode edge portion of at least one of first electrode 11 or second electrode 12 exposed on first mounting surface 1a with the linear electrode edge portion of an electrode of electronic component 2 that is to be bonded thereto; therefore, an inclined mounting module with small rotational misalignment of electronic component 2 on first mounting surface 1a (inclined surface) can be obtained.

In this case, the linear electrode edge portion of either first electrode 11 or second electrode 12 on first mounting surface 1a may have the same length as the linear electrode edge portion of electronic component 2 that is to be bonded via solder. In another form, the linear electrode edge portions of both first electrode 11 and second electrode 12 may have the same length as the opposing linear electrode edge portions of the paired electrodes of electronic component 2. With such a configuration, solder that melts and solidifies acts to match the length of the linear electrode edge portion of at least one of first electrode 11 or second electrode 12 exposed on first mounting surface 1a with the length of the linear electrode edge portion of an electrode of electronic component 2 that is to be bonded thereto; therefore, misalignment of electronic component 2 on first mounting surface 1a can be reduced in both the rotational direction and the inclination direction. Accordingly, an inclined mounting module suitable for precise control of the mounting position can be obtained. Note that, by making the electrode spacing between first electrode 11 and second electrode 12 on first mounting surface 1a equal to the electrode spacing between the paired electrodes on the rear surface of electronic component 2, misalignment of electronic component 2 can be further reduced.

In Embodiment 1, the electronic devices including an inclined mounting module and a circuit module have been described with reference to electronic device 300 illustrated in FIG. 17 and electronic device 300X illustrated in FIG. 18 as examples; however, the present disclosure is not limited to these forms.

For example, although electronic device 300 (illumination device) illustrated in FIG. 17 includes circuit module 201 illustrated in FIG. 10, the present disclosure is not limited thereto. Specifically, any of the circuit modules or inclined mounting modules illustrated in FIG. 11 through FIG. 16 may be included instead.

Further, electronic device 300X serving as a detection device or an evaluation device may also include any of the circuit modules or inclined mounting modules illustrated in FIG. 10 through FIG. 16. In the case of combining a solid-state light-emitting element and a light detection element, the solid-state light-emitting element and the light detection element may be disposed in a manner that primary light emitted by the solid-state light-emitting element is directly incident on the light-receiving surface of the light detection element, or that the primary light is not directly incident on the light-receiving surface of the light detection element. In the latter case, the light detection element may be configured to detect a light component reflected or diffused by substance 8 when substance 8 is present in front of a light extraction surface of the solid-state light-emitting element. This configuration makes it possible to effectively suppress detection of stray light of the primary light emitted by the solid-state light-emitting element.

Note that the concept of electronic devices according to the present invention broadly includes electronic device systems. For example, the electronic devices according to the present invention also include electronic device systems in which various types of software including machine learning, or control systems including robots, are combined. This enables implementation of electronic devices applicable to automation and the like.

The present invention also includes: other forms obtained through various modifications of the above embodiments conceived by a person skilled in the art; and forms implemented by freely combining the constituent elements and the functions in the above embodiments within a scope not departing from the essence of the present invention. The present invention also includes forms obtained by freely combining one or more constituent elements recited in each of the plurality of claims of the present application as originally filed. Further, when a dependent claim included in the claims of the present application as originally filed is a multiple dependent claim or a nested multiple dependent claim dependent on any combination of claims (for example, dependent on all the preceding claims), the present invention also includes all forms that can be obtained by combinations of all the claims included in such a multiple dependent claim or a nested multiple dependent claim.

### [Reference Signs List]

1, 1A, 1B, 1C, 1F, 1F', 1G, 1H, 1I, 1J, 1K, 1L support
1a first mounting surface
1b second mounting surface
2, 2X electronic component
2a mounting surface
3, 3A circuit board
11, 11A first electrode
12, 12A second electrode
20 receiving portion
30 suction portion
100, 100A, 100B, 100C, 100F, 100F', 100K, 100X inclined mounting module
200, 201, 202, 203, 204, 205, 206 circuit module
300, 300X electronic device

## Claims

1. A support to be mounted on a board while supporting an electronic component, the support comprising, at least:
one or more first mounting surfaces on which a mounting surface of the electronic component is to be mounted;
a second mounting surface via which the support is to be mounted on the board;
a first electrode and a second electrode each of which is made of a metal material and is exposed on both the one or more first mounting surfaces and the second mounting surface; and
a receiving portion that receives a surface of the electronic component different from the mounting surface of the electronic component, wherein
the one or more first mounting surfaces are each inclined at an inclination angle of at least 5 degrees and at most 85 degrees relative to the second mounting surface, and
the first electrode and the second electrode function as principal thermal conductors of the support and conduct heat from the one or more first mounting surfaces to the second mounting surface.

2. The support according to claim 1, wherein
the metal material has a thermal conductivity of at least 200 W/m·K at room temperature.

3. The support according to claim 1, wherein
the metal material contains at least 30 wt% copper.

4. The support according to claim 3, wherein
a volume fraction of the metal material in the support is at least 30%.

5. The support according to claim 1, wherein
the receiving portion prevents the electronic component disposed on the one or more first mounting surfaces from moving in a direction in which a distance between the one or more first mounting surfaces and the second mounting surface decreases.

6. The support according to claim 5, wherein
the receiving portion is a protruding portion protruding from the one or more first mounting surfaces.

7. The support according to any one of claims 1 to 6, comprising:
a suction portion to which a suction nozzle is to be attached by suction when the support is mounted on the board, wherein
the suction portion is a plane that is located on a back side of the second mounting surface and is parallel to the second mounting surface.

8. An inclined mounting module comprising:
the support according to claim 1; and
an electronic component mounted on the one or more first mounting surfaces of the support.

9. The inclined mounting module according to claim 8, wherein
the electronic component is a solid-state light-emitting element or a detection element.

10. A circuit module comprising:
the inclined mounting module according to claim 8; and
a board on which the support in the inclined mounting module is mounted, wherein
the support is mounted on the board via the second mounting surface, and
the board is a circuit board.

11. An electronic device comprising:
at least one of the inclined mounting module according to claim 8 or the circuit module according to claim 8.

12. A method for manufacturing the circuit module according to claim 10, the method comprising:
a first placing process of placing an electronic component on the one or more first mounting surfaces of the support via a first mounting material;
a second placing process of placing the support on an electrode of the circuit board via a second mounting material; and
a mounting process of mounting the electronic component on the support using the first mounting material and mounting the support on the circuit board using the second mounting material, wherein
the mounting process is performed after the first placing process and the second placing process.

13. A method for manufacturing the circuit module according to claim 10, the method comprising:
a first mounting process of mounting an electronic component on the one or more first mounting surfaces of the support;
an inclining process of inclining the support on which the electronic component has been mounted, the inclining process being performed after the first mounting process; and
a second mounting process of mounting, on an electrode of the circuit board, the support on which the electronic component has been mounted, the support being mounted via the second mounting surface, the second mounting process being performed after the inclining process, wherein
a first mounting direction in which the electronic component is mounted on the support in the first mounting process and a second mounting direction in which the support is mounted on the electrode of the circuit board in the second mounting process are a same direction.
